# EUROPEAN PATENT SPECIFICATION

(11) **EP 3 187 555 B1**
(45) Date of publication and mention of the grant of the patent: **23.08.2023**
(21) Application number: 15834909.2
(22) Date of filing: 10.08.2015
(51) Int. Cl.: H01L 21/00

(54) **MALEIMIDE FILM**
MALEIMIDFILM
FILM DE MALÉIMIDE

(30) Priority: 29.08.2014 JP 2014176054
(43) Date of publication of application: 05.07.2017
(73) Proprietor: Furukawa Electric Co., Ltd., Chiyoda-ku Tokyo (JP)
(72) Inventor: AOYAMA, Masami, Tokyo 100-8322 (JP); KIRIKAE, Noriyuki, Tokyo 100-8322 (JP)
(74) Representative: Hermann, Felix
(86) International application number: PCT/JP2015/072718
(87) International publication number: WO 2016/031555

(56) References cited:
- WO-A1-2012/160916
- JP-A- H05 271 535
- JP-A- 2004 083 762
- JP-A- 2004 197 010
- JP-A- 2006 160 910
- JP-A- 2006 526 014
- JP-A- 2010 059 387
- JP-A- 2011 001 473
- JP-A- 2013 041 911
- ARKEMA: "LUPEROX? Organic Peroxides", GENERAL CATALOGUE - AMERICAS, 1 January 2004 (2004-01-01), pages 1pp, 1-10, 1pp, XP055352828,

## Description

### TECHNICAL FIELD

The present invention relates to a maleimide adhesive film, which is suitable for the production of electronic equipments, integrated circuits, semiconductor devices, passive devices, solar batteries, solar modules, and/or light emitting diodes.

### Background Art

Adhesive resin compositions are used for various purposes in the production and assembly of microelectronic devices such as semiconductor packages. More noticeable uses are the bonding of electronic devices such as integrated circuit chips on to lead frames or other substrates, and the bonding of circuit packages and assembly on to printed circuit boards. In such adhesion processes, the adhesive resin composition is required to flow and fill the space between the adherends so that no bubbles (void) enter the boundary of the adherends, and further, to avoid the generation of voids by heating during the sealing, reflow or mounting process following the adhesion process. In devices in which voids are generated, peeling occurs at the boundary and become insufficient in reliability. Further, if the adhesion is insufficient, wire bonding defect may occur, or the sealing resin may enter the boundary during the sealing process.

Further, in recent years, multi-stage mounting of semiconductor chips and three-dimensional mounting, in which different semiconductors are laminated and connected, are being actively pursued, causing the time in which semiconductor products are subjected to heat to lengthen. Thus, highly reliable adhesive resin compositions that show high resistivity against thermal history are required. In regard to such subject, for example, in Patent Document 1, an adhesive film for semiconductor, which comprises an acrylic copolymer containing glycidyl group and high molecular-weight epoxy resin, is disclosed.

### RELATED ART

### Patent Documents

Patent Document 1: JP-A-2012-191046
Patent Document 2: WO 2012/160916 A1
Patent Document 3: JP 2004 197010 A
Patent Document 4: JPH05 271535 A
Patent Document 5: JP 2011 001473 A
Patent Document 6: JP 2010 059387 A
Patent Document 7: JP 2006 526014 A

### SUMMARY

Further, in recent years, demands for application in power devices and vehicle devices, which are left under high temperature for a long time even during use, are increasing, and higher heat-resistance is required.

In order to solve the above problems, the present inventors provide a maleimide film that utilizes maleimide resin, which shows excellent resistivity against thermal deterioration.

That is, the present invention provides a maleimide adhesive film, which comprises a maleimide resin and a radical initiator with a one-hour half-life temperature of 200°C or higher. The maleimide resin has the mass-average molecular weight 1,000 or more and is selected from General Formula (2),(3),(4) or comprises a polymer that contains a plurality of pendant repeating units having the structural formula of General Formula (6).

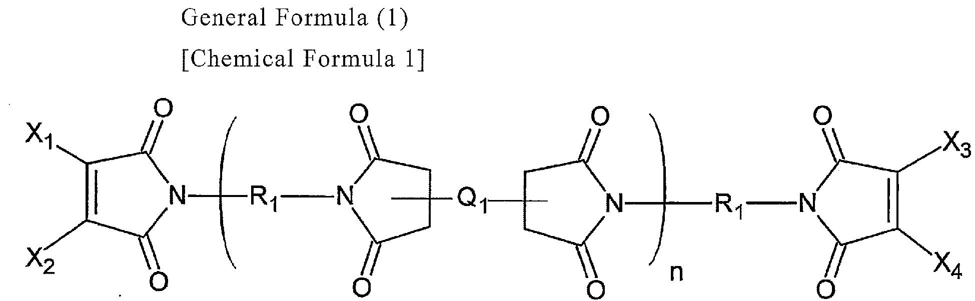

(In the formula, R₁ and Q₁ are independently selected from the group consisting of structures derived from unsubstituted or substituted aliphatic, alicyclic, alkenyl, aryl, heteroaryl, siloxane, poly(butadiene-co-acrylonitrile) and poly(alkylene oxide). X₁ to X₄ are independently H or an alkyl group with 1 to 6 carbons. n = 0 to 30.)

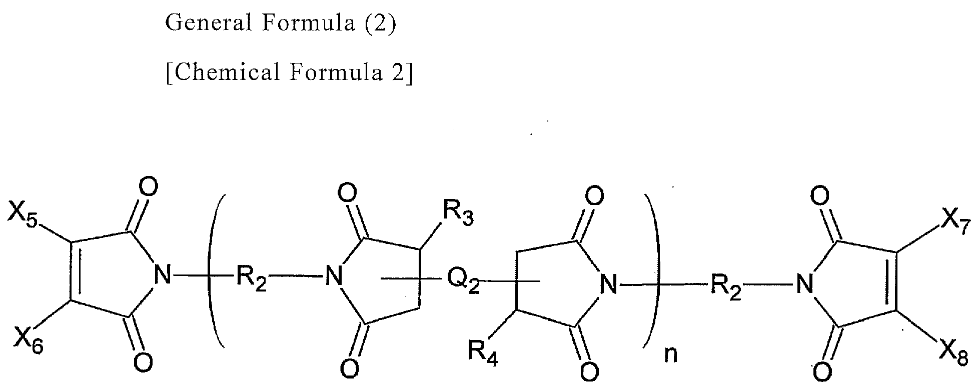

(In the formula, R₂ and Q₃ are independently selected from the group consisting of structures derived from unsubstituted or substituted aliphatic, alicyclic, alkenyl, aryl, heteroaryl, siloxane, poly(butadiene-co-acrylonitrile) and poly(alkylene oxide). X₅ to X₈ are independently H or an alkyl group with 1 to 6 carbons. R₃ and R₄ are independently H or CH₃. n = 0 to 30.)

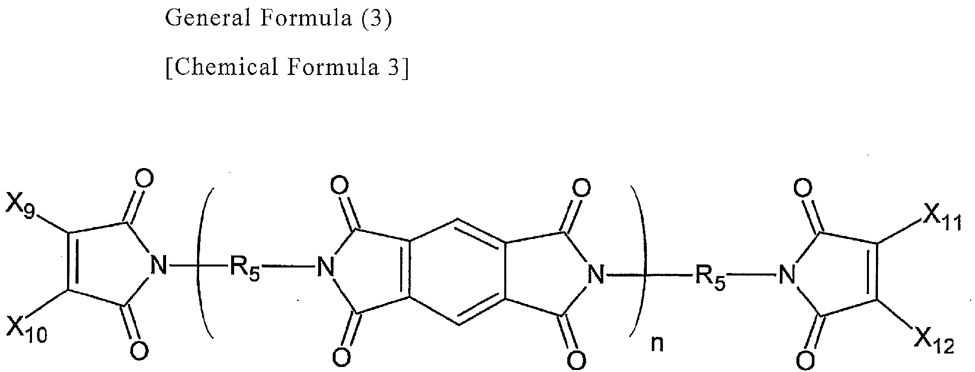

(In the formula, R₅ is independently selected from the group consisting of structures derived from unsubstituted or substituted aliphatic, alicyclic, alkenyl, aryl, heteroaryl, siloxane, poly(butadiene-co-acrylonitrile) and poly(alkylene oxide). X₉ to X₁₂ are independently H or an alkyl group with 1 to 6 carbons. n = 0 to 30.)

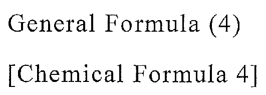

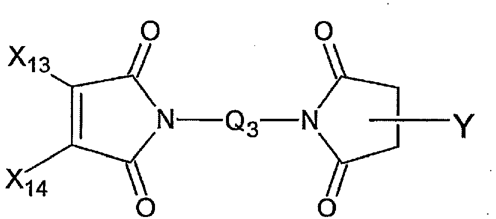

(In the formula, Q₃ is independently selected from the group consisting of structures derived from unsubstituted or substituted aliphatic, alicyclic, alkenyl, aryl, heteroaryl, siloxane, poly(butadiene-co-acrylonitrile) and poly(alkylene oxide). X₁₃, X₁₄ are independently H or an alkyl group with 1 to 6 carbons. Y is a substituted or unsubstituted aliphatic or aromatic.)

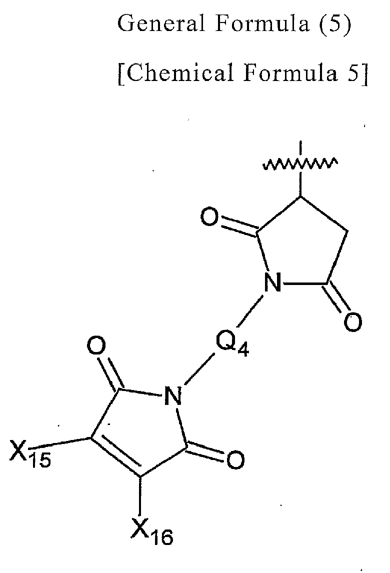

(In the formula, Q₄ is a substituted or unsubstituted aliphatic part, aromatic part, heteroaromatic part, or siloxane part. X₁₅ and X₁₆ are independently H or an alkyl group with 1 to 6 carbons.)

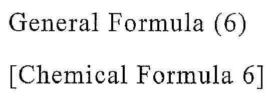

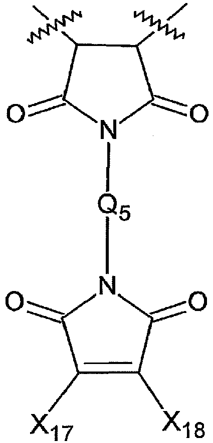

(In the formula, Q₅ is a substituted or unsubstituted aliphatic part, aromatic part, heteroaromatic part, or siloxane part. X₁₇ and X₁₈ are independently H or an alkyl group with 1 to 6 carbons.)

Further, one of R₁, R₂, R₅, Q₁, Q₂, Q₃, Q₄, Q₅ preferably has a cyclic structure. Specifically, it is preferably one of the structures indicated in General Formula (7).

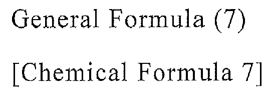

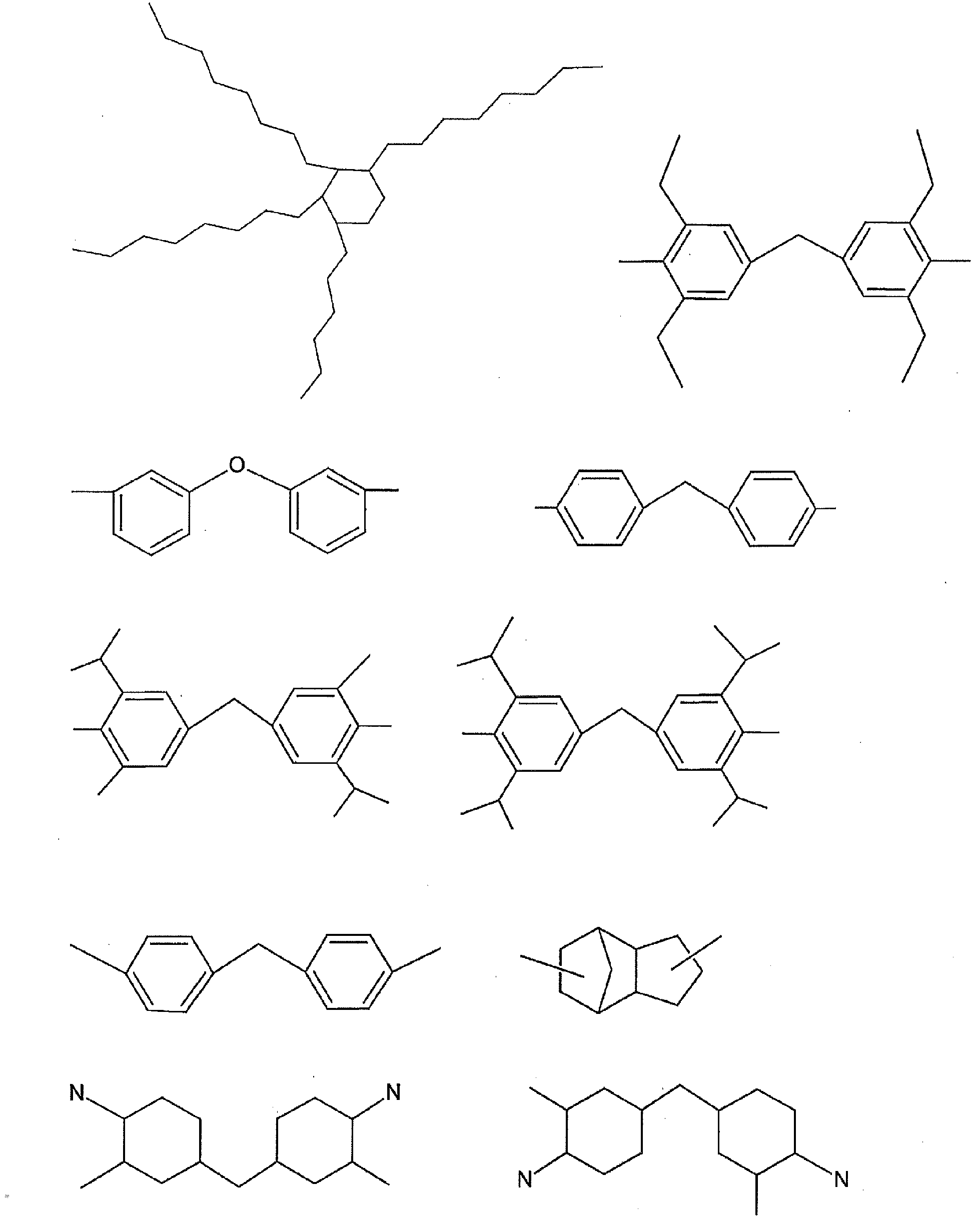

Further, it is preferable that the siloxane part is dimethylsiloxane, methylphenylsiloxane, diphenylsiloxane, or a combination there of.

Furthermore, the above structures derived from substituted aliphatic, alicyclic, alkenyl, aryl, heteroaryl, siloxane, poly(butadiene-co-acrylonitrile) and poly(alkylene oxide) are alkyl group, alkenyl group, alkynyl group, hydroxyl group, oxo group, alkoxy group, mercapto group, cycloalkyl group, substituted cycloalkyl group, heterocyclic group, substituted heterocyclic group, aryl group, substituted aryl group, heteroaryl group, substituted heteroaryl group, aryloxy group, substituted aryloxy group, halogen, haloalkyl group, cyano group, nitro group, nitrone group, amino group, amide group, -C(O)H, acyl group, oxyacyl group, carboxyl group, carbamate group, sulfonyl group, sulfonamide group, sulfuryl group, or -C(O)-, -S-, -S(O)₂-, -OC(O)-O-, -NA-C(O)-, -NAC(O)-NA-, -OC(O)-NA-, (in the formula, A is H or an alkyl group with 1 to 6 carbons), and it is preferable that one terminal further contains a substituent that is selected from the substituted groups.

Further, it is preferable that the above-described maleimide resin composes 50 mass% or more of the resin component.

Further, it is preferable that it contains a filler.

The present invention relates to a maleimide adhesive film with dicing tape, which comprises such maleimide film laminated on a dicing tape.

### Effect of the Invention

The present invention successfully provides a maleimide film that utilizes maleimide resin that shows high heat history resistance and is highly reliable, as well as an adhesive film with dicing tape that is obtained by laminating such maleimide film on a dicing tape.

### BRIEF DESCRIPTION OF DRAWINGS

[FIG. 1] FIG. 1 shows an adhesive film with dicing tape that utilizes and comprises the adhesive agent of the present invention.
[FIG. 2] FIG. 2 is a sectional scheme of an embodiment of the adhesive film with dicing tape that differs from FIG. 1.

### DESCRIPTION OF SOME EMBODIMENTS

### <Description of Terms>

In the present description, the term "setting" in "thermosetting" refers to the irreversible reaction that forms a single three-dimensional network from compounds, compositions etc., wherein the three-dimensional network shows larger strength and lower solubility than that prior to setting. Thermosetting refers to the property of being capable of typically setting by chemical reaction (for example, epoxy ring-opening, radical polymerization) via heat.

In the present description, "crosslinking" refers to the bonding of two or more elements, molecular groups, compounds, or other oligomers or polymers, that lead to chain-lengthening. Crosslinking is typically performed by exposing to light and energy rays or by heating. Some crosslinking processes may be performed at temperatures lower than room temperature. When the crosslinking density increases, the material property can be changed from curable to thermoplasticity.

The term "C36" used in the present description refers to all possible structural isomers of the 36 aliphatic parts containing branched chains and cyclic isomers with a maximum of three carbon-carbon double bonds in the main chain. One non-limiting example of a part that the description of "C36" refers to is a part containing a cyclohexane-based core and four long "arms" attached to the core, as described in the following General Formula (8).

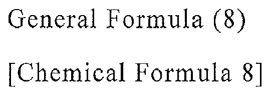

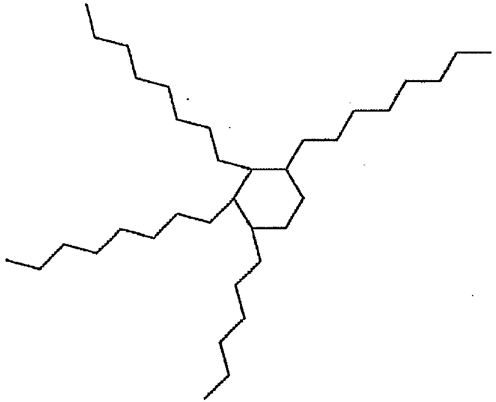

In the present description, "heterocyclic group" refers to a cyclic structure-containing group that contains at least one hetero atom (for example, N, O, S etc.) with 3 to 14 carbon atoms, and "substituted heterocyclic group" refers to the aforementioned heterocyclic group with one or more substituents.

In the present description, "imide" refers to a functional group with two carbonyl groups bonded to a primary amine or ammonia. The general formula for the imide of the present invention is as shown in the following General Formula (9). Note that R, R', R" are arbitrary functional groups that may be applied for practical purposes.

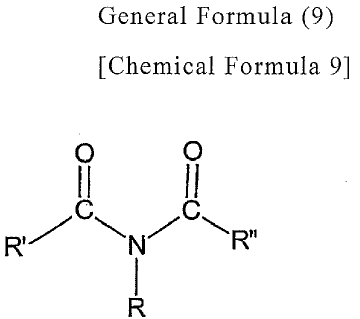

In the present description, "polyimide" refers to a polymer of a imide-group-containing monomer. Polyimide is typically linear or cyclic. Non-limiting examples of linear and cyclic polyimides (for example, aromatic heterocyclic polyimide) are as shown in General Formula (10). Note that R is an arbitrary functional group that may be applied for practical purposes.

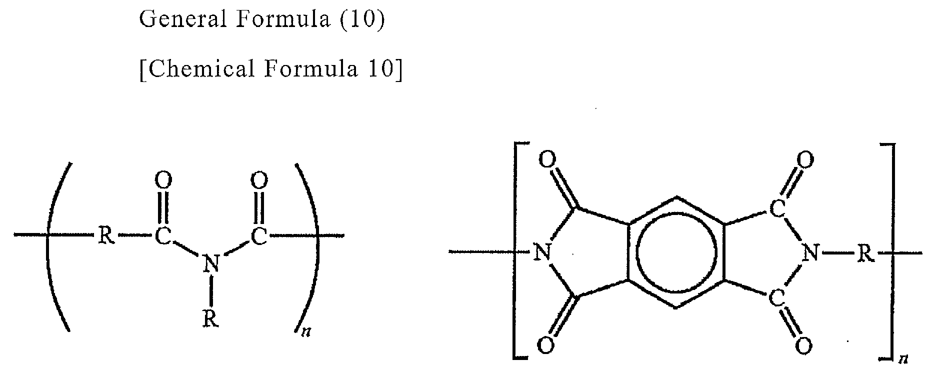

In the present description, "maleimide" refers to N-substituted maleimide with the structure indicated in the following General Formula (11).

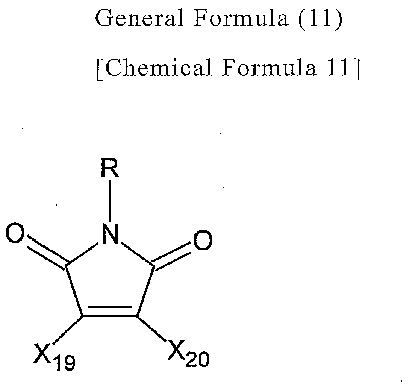

R is an aromatic, heteroaromatic, aliphatic, or polymeric part. X₁₉, X₂₀ are independently H or alkyl with 1 to 6 carbons.

In the present description, "bismaleimide" or "BMI" refers to a polyimide compound to which two imide parts are connected by crosslinking. The general formula is as shown in General Formula (12). 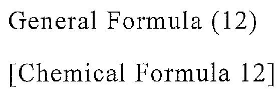 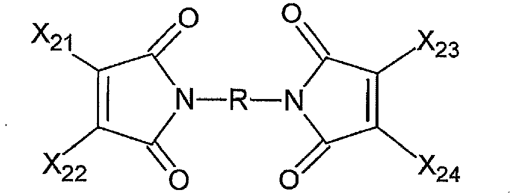
R is an aromatic, heteroaromatic, aliphatic, or polymeric part.
X₂₁ to X₂₄ are independently H or alkyl with 1 to 6 carbons.

BMI may be cured by addition, which can avoid the problems caused by the formation of volatile substances. BMI may be cured by vinyl polymerization of prepolymers with two maleimide groups at the terminal.

In the present description, "imide extended" refers to the state in which a compound has at least one imide part at a position other than the terminal of the molecule.

In the present description, the term "pendant" refers to the state in which the above-described structure is bonded to the main chain of the polymer by at least one covalent bond.

### <Maleimide Resin>

When inserted into a thermosetting composition, in particular, the maleimide resins with extended imides shown in the following list may enhance toughness and reduce brittleness in the composition without sacrificing its thermal stability.

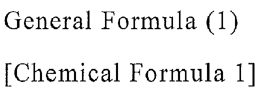

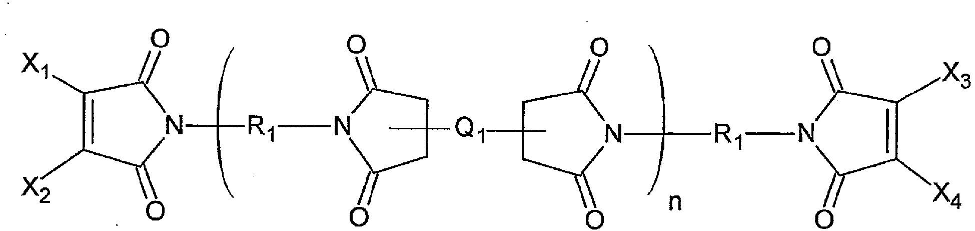

(In the formula, R₁ and Q₁ are independently selected from the group consisting of structures derived from unsubstituted or substituted aliphatic, alicyclic, alkenyl, aryl, heteroaryl, siloxane, poly(butadiene-co-acrylonitrile) and poly(alkylene oxide). X₁ to X₄ are independently H or an alkyl group with 1 to 6 carbons. n = 0 to 30.)

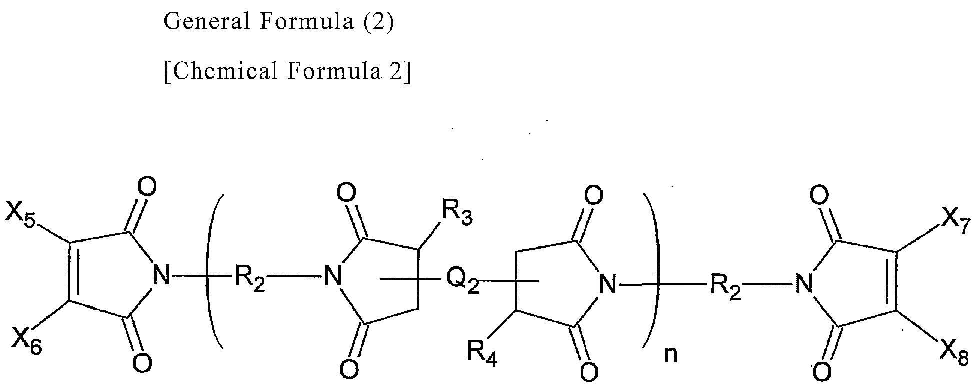

(In the formula, R₂ and Q₂ are independently selected from the group consisting of structures derived from unsubstituted or substituted aliphatic, alicyclic, alkenyl, aryl, heteroaryl, siloxane, poly(butadiene-co-acrylonitrile) and poly(alkylene oxide). X₅ to X₈ are independently H or an alkyl group with 1 to 6 carbons. R₃ and R₄ are independently H or CH₃. n = 0 to 30.)

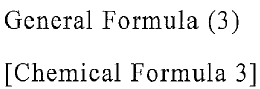

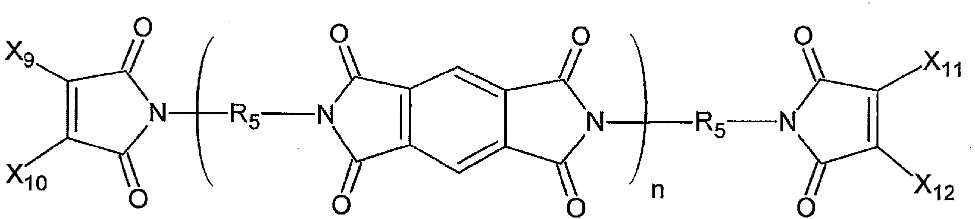

(In the formula, R₅ is independently selected from the group consisting of structures derived from unsubstituted or substituted aliphatic, alicyclic, alkenyl, aryl, heteroaryl, siloxane, poly(butadiene-co-acrylonitrile) and poly(alkylene oxide). X₉ to X₁₂ are independently H or an alkyl group with 1 to 6 carbons. n = 0 to 30.)

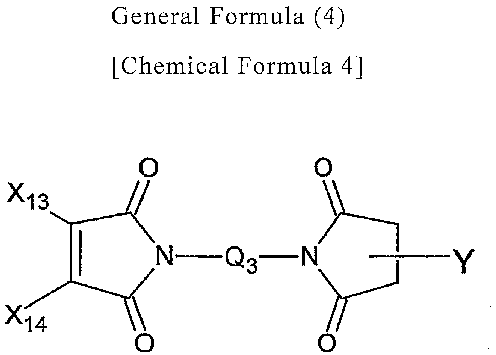

(In the formula, Q₃ is independently selected from the group consisting of structures derived from unsubstituted or substituted aliphatic, alicyclic, alkenyl, aryl, heteroaryl, siloxane, poly(butadiene-co-acrylonitrile) and poly(alkylene oxide). X₁₃, X₁₄ are independently H or an alkyl group with 1 to 6 carbons. Y is an unsubstituted or substituted aliphatic or aromatic.)

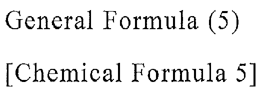

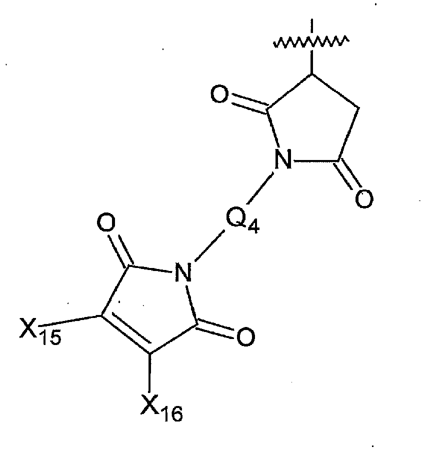

(In the formula, Q₄ is a substituted or unsubstituted aliphatic part, aromatic part, heteroaromatic part, or siloxane part. X₁₅ and X₁₆ are independently H or an alkyl group with 1 to 6 carbons.)

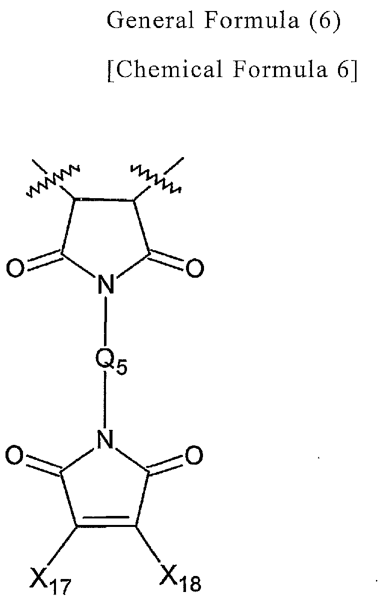

(In the formula, Q₅ is a substituted or unsubstituted aliphatic part, aromatic part, heteroaromatic part, or siloxane part. X₁₇ and X₁₈ are independently H or an alkyl group with 1 to 6 carbons.)

Here, in an embodiment, R₁, R₂, R₅, Q₁, Q₂, Q₃, Q₄, and Q5 are independently substituted or unsubstituted linear, branched, or cyclic aliphatic parts with 2 to about 100 carbon atoms. In another embodiment, R and Q are independently substituted or unsubstituted aromatic or heteroaromatic parts with 6 to about 14 carbon atoms. In another embodiment, R and Q are independently substituted or unsubstituted siloxane parts with 2 to about 50 silicon atoms. In several embodiments, R and Q are independently polysiloxane parts such as dimethyl siloxane, methylphenyl siloxane, diphenyl siloxane, or combinations thereof.

As such siloxane part, dimethyl siloxane, methylphenyl siloxane, diphenyl siloxane, or combinations thereof are preferable.

The structure derived from substituted aliphatic, alicyclic, alkenyl, aryl, heteroaryl, siloxane, poly(butadiene-co-acrylonitrile) and poly(alkylene oxide) are alkyl group, alkenyl group, alkynyl group, hydroxyl group, oxo group, alkoxy group, mercapto group, cycloalkyl group, substituted cycloalkyl group, heterocyclic group, substituted heterocyclic group, aryl group, substituted aryl group, heteroaryl group, substituted heteroaryl group, aryloxy group, substituted aryloxy group, halogen, haloalkyl group, cyano group, nitro group, nitrone group, amino group, amide group, -C(O)H, acyl group, oxyacyl group, carboxyl group, carbamate group, sulfonyl group, sulfonamide group, sulfuryl group, or -C(O)-, -S-, -S(O)₂-, -OC(O)-O-, -NA-C(O)-, -NAC(O)-NA-, -OC(O)-NA-, (in the formula, A is H or an alkyl group with 1 to 6 carbons), and it is preferable that one terminal further contains a substituent that is selected from the substituted groups.

Such maleimide resin may be obtained by bringing a dianhydride into contact with a diamine under suitable condition to form imide with a terminal amino part, then bringing the terminal amino part with maleic anhydride under suitable condition to form a maleimide, to thereby produce a maleimide with extended imide.

When the above R₁, R₂, R₅, Q₁, Q₂, Q₃, Q₄, and Q5 contain sturctures derived from substituted or unsubstituted aliphatic, alicyclic, alkenyl, aryl, heteroaryl, siloxane,poly(butadiene-co- acrylonitrile) and poly(alkylene oxide), the substituents may be alkyl group, alkenyl group, alkynyl group, hydroxyl group, oxo group, alkoxy group, mercapto group, cycloalkyl group, substituted cycloalkyl group, heterocyclic group, substituted heterocyclic group, aryl group, substituted aryl group, heteroaryl group, substituted heteroaryl group, aryloxy group, substituted aryloxy group, halogen, haloalkyl group, cyano group, nitro group, nitrone group, amino group, amide group, -C(O)H, acyl group, oxyacyl group, carboxyl group, carbamate group, sulfonyl group, sulfonamide group, sulfuryl group, or -C(O)-, -S-, -S(O)₂-, -OC(O)-O-, -NA-C(O)-, -NAC(O)-NA-, -OC(O)-NA-, (in the formula, A is H or an alkyl group with 1 to 6 carbons), acyl group, oxyacyl group, carboxyl group, carbamate group, sulfonyl group, sulfonamide group, or sulfuryl group.

Note that one of R₁, R₂, R₅, Q₁, Q₂, Q₃, Q₄, Q5 preferably has a cyclic structure.

It is further preferable that the cyclic structure has one of the structures shown in the following General Formula (7).

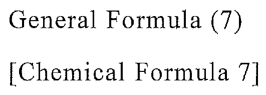

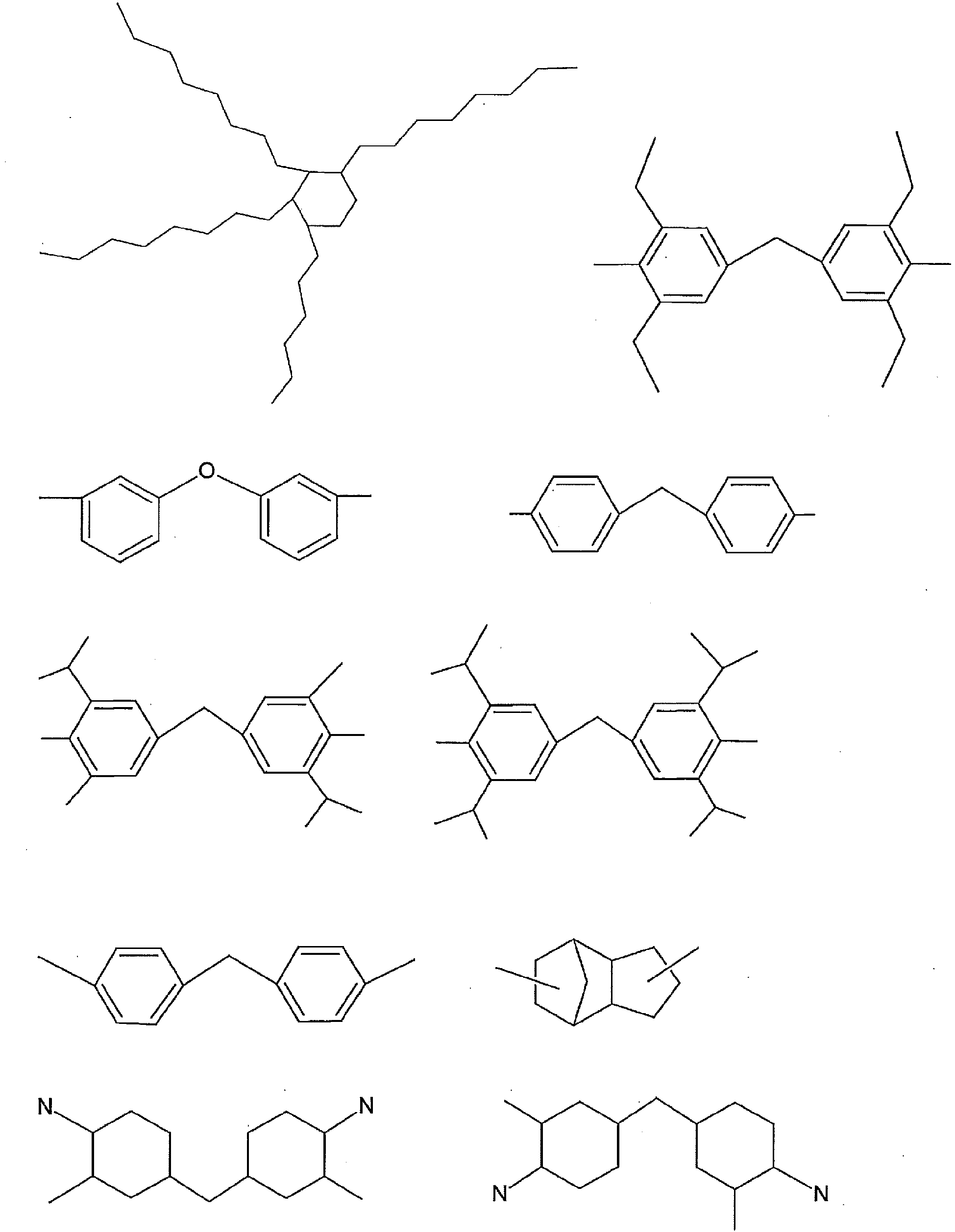

In several embodiments, Y is a substituted or unsubstituted linear, branched, or cyclic aliphatic parts with 2 to about 100 carbon atoms. In another embodiment, R₁ is a substituted or unsubstituted aromatic or heteroaromatic parts with 6 to about 14 carbon atoms.

When Y is substituted, the substituents present are the same as R₁, R₂, R₅, Q₁, Q₂, Q₃, Q₄, and Q5.

As specific examples of the maleimide shown in General Formula (2), for example, those shown in the following General Formula (13) may be listed, but are not limited to these.

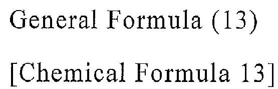

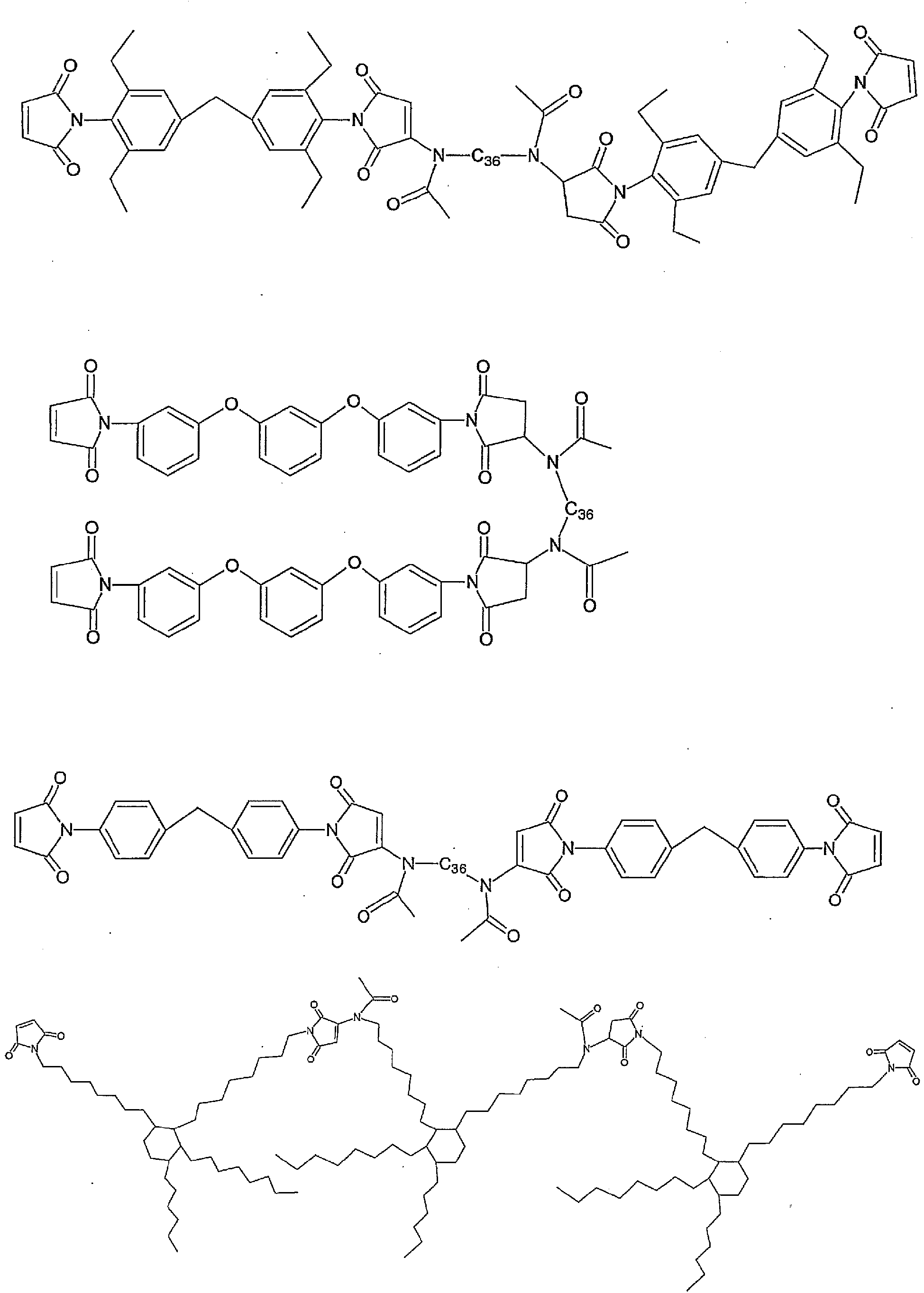

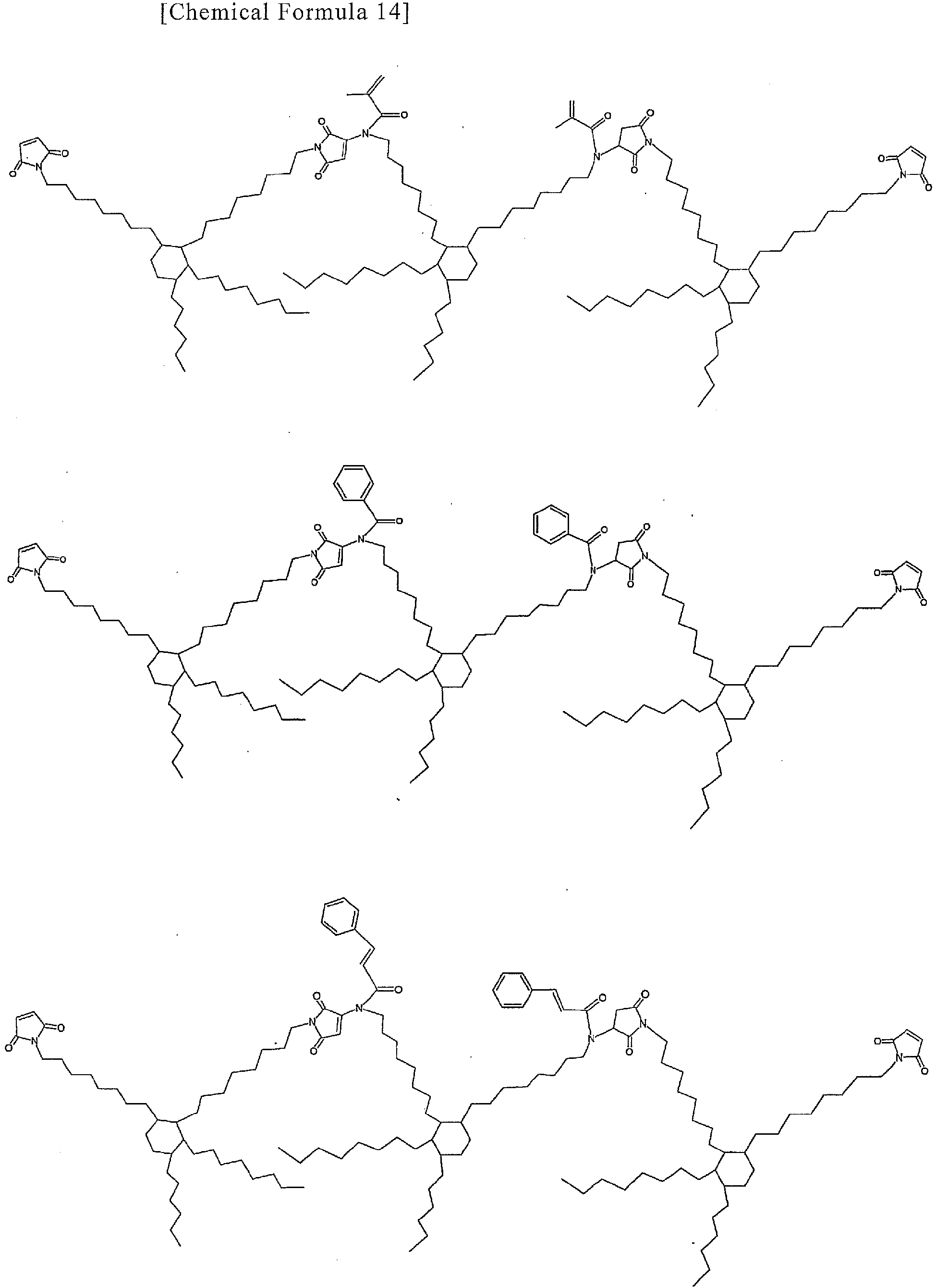

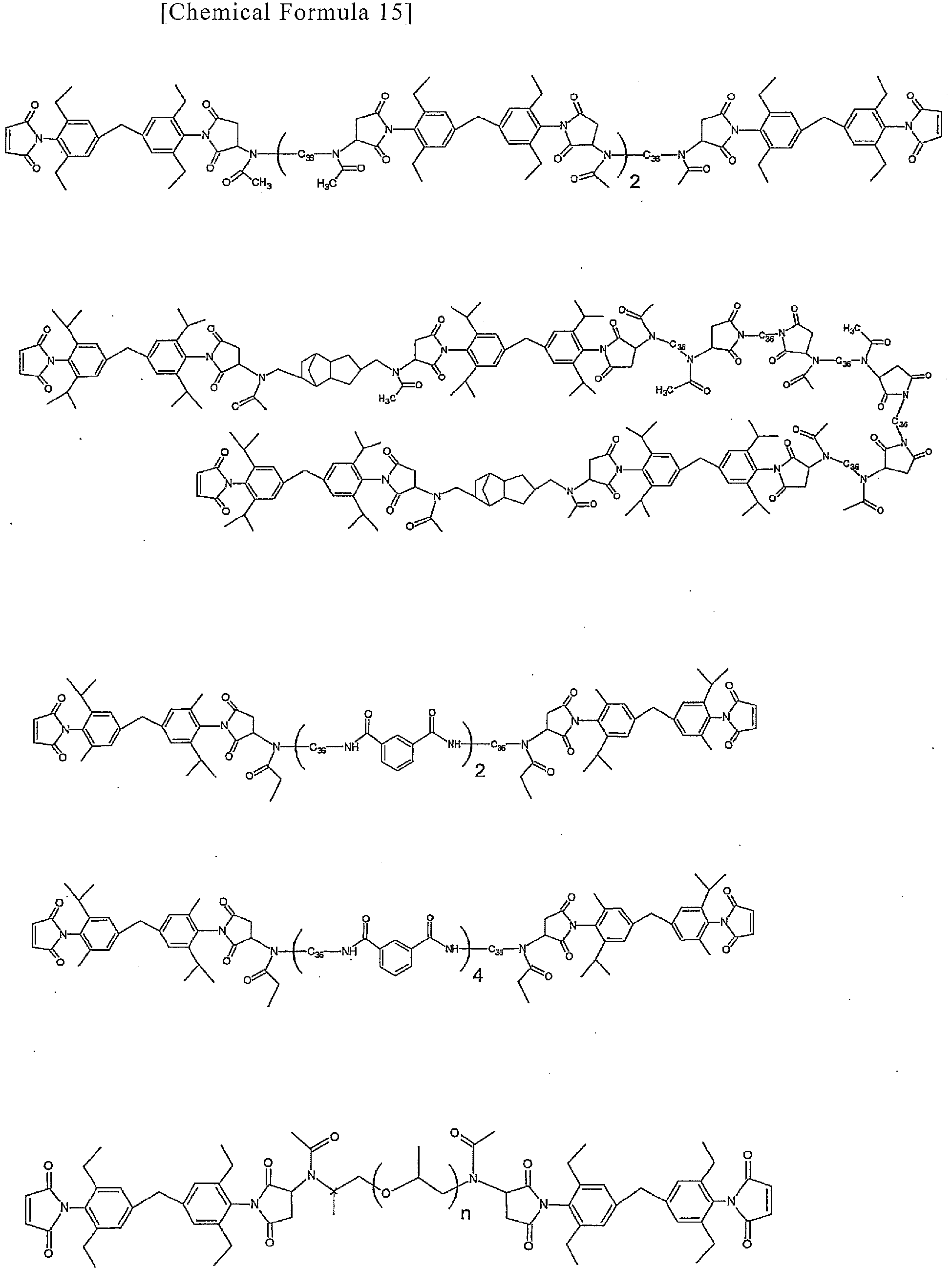

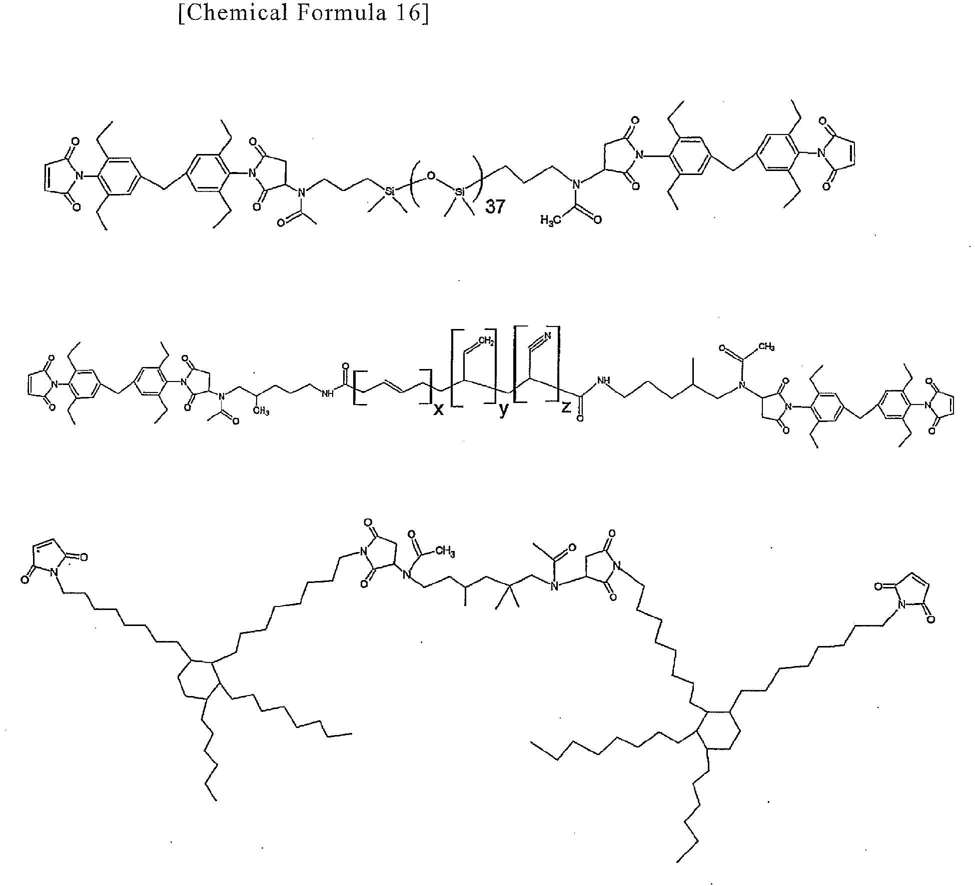

As specific examples of the maleimide shown in General Formula (3), for example, those shown in the following General Formula (14) may be listed, but are not limited to these. (n is 0 to 20.)

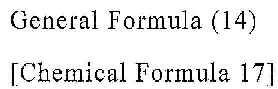

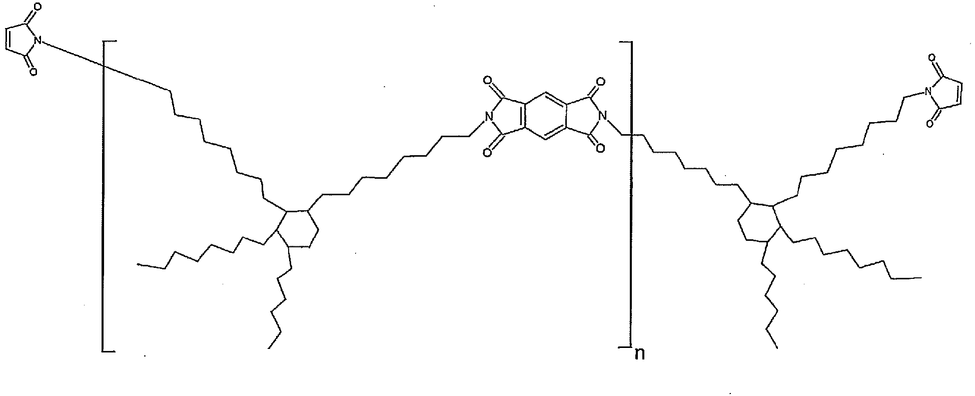

As a specific example of the polyimide shown in General Formula (4), for example, a structure obtained by adding a substituted or unsubstituted aliphatic or aromatic group to the double bond of the maleimide structure in one end of the compounds shown in General Formula (1) to (3) may be listed.

As a specific example of the polyimide shown in General Formula (4), for example, those shown in General Formula (15) may be listed. Precursor polymers or oligomers with succinic anhydride functional groups at the pendant (top part) or main chain (bottom part) are known in the present technical field. Examples of such substance are polyolefins grafted with succinic anhydride residues (for example, polyethylene, polypropylene, and similar substances), polybutadiene grafted with succinic anhydride residues, alternating copolymers or random copolymers of succinic anhydride and styrene or alpha-olefin, and similar substances. In the preparation of the polymaleimide of the present invention, these are used to suppress crosslinking reaction where excess diamines are not favorable.

R_{N} is an aromatic, heteroaromatic, aliphatic, or polymeric part.

X_{N} are independently H or alkyl with 1 to 6 carbons.

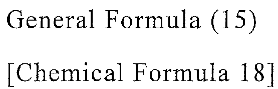

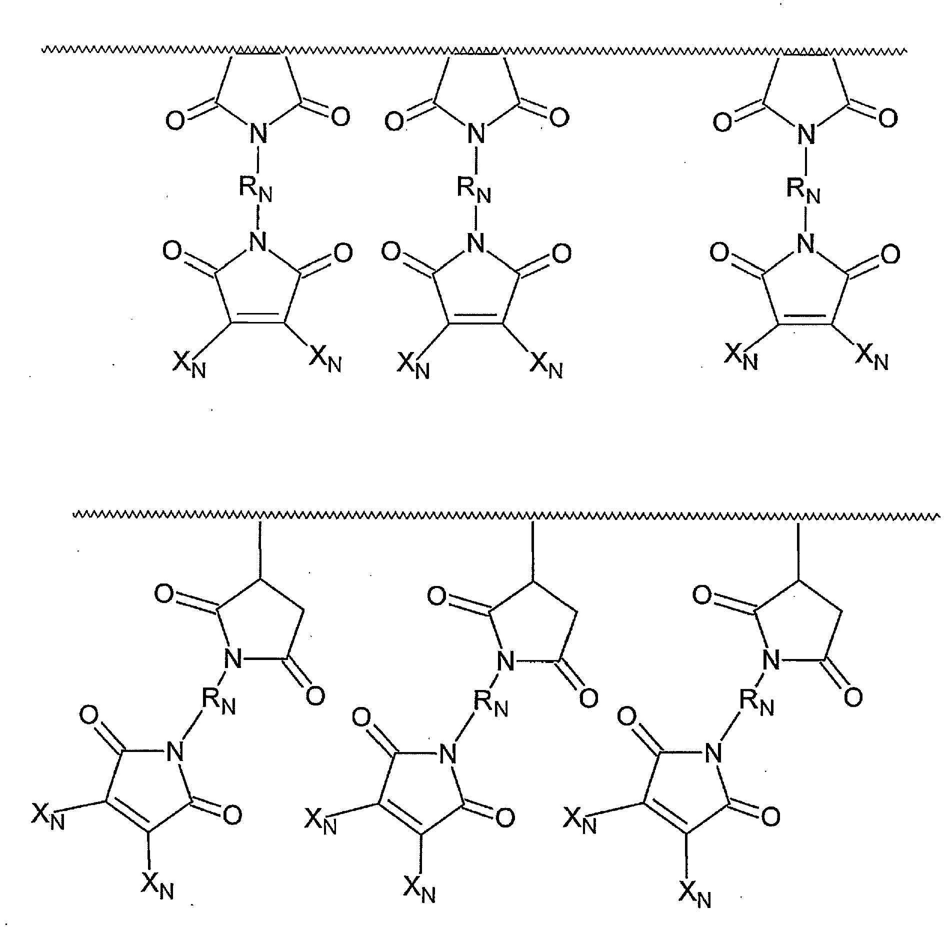

As specific examples of the polyimide shown in General Formula (5), for example, those shown in the following General Formula (16) may be listed.

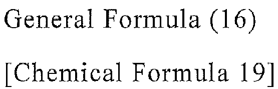

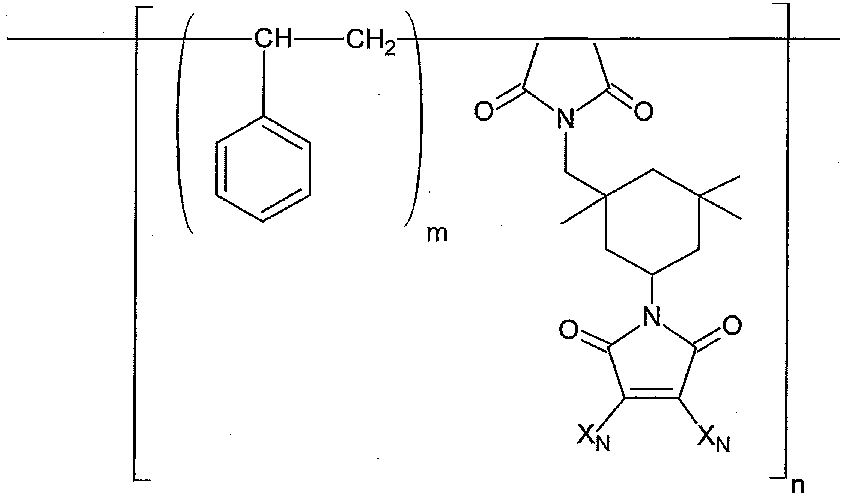

Here, Xₙ is independently H or an alkyl group with 1 to 6 carbons, m is 1 to 10, n is 3 to 20.

Other examples of the maleimide are, for example, those shown in the following General Formula (17) may be listed but are not limited to these.

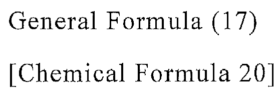

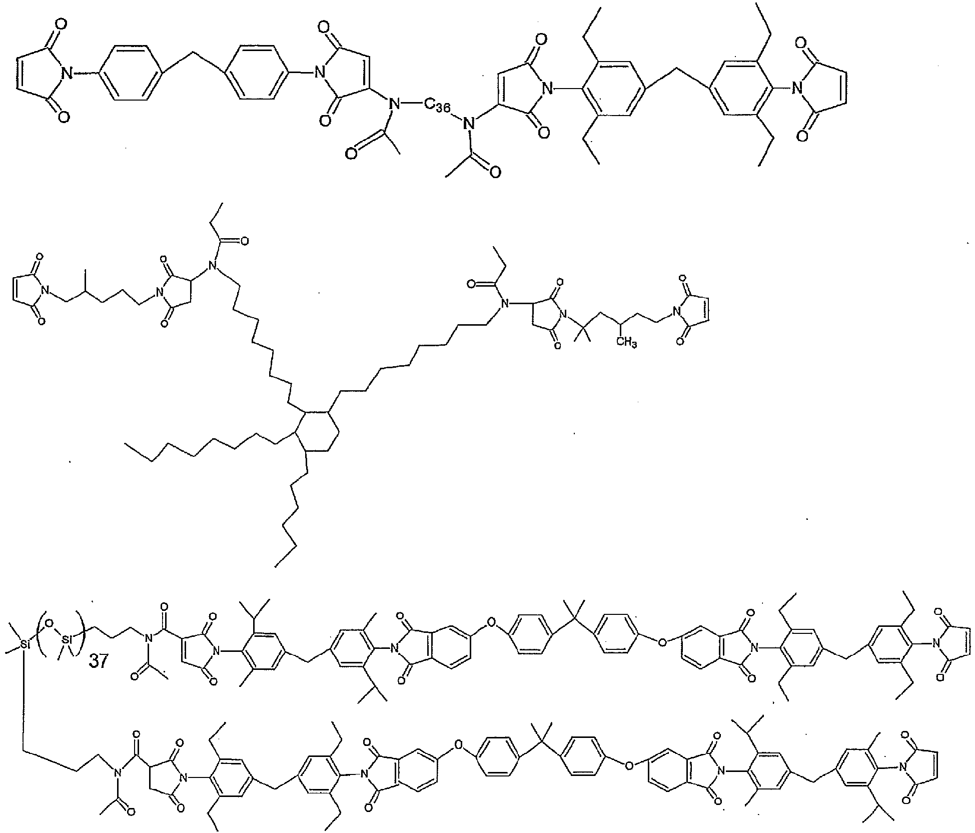

In the present invention, the maleimide resin may be used in the film independently, or may be used in combination with other adhesive compounds or resins. In one embodiment, the maleimide resin may be the single thermosetting resin in the adhesive composition. In another embodiment, one or more maleimide resin may be used in combination or a maleimide resin and another thermosetting resin may be used together.

According to the invention, when the mass-average molecular weight of the maleimide resin is 1,000 or more, film-formation becomes easy, and 2,000 or more is more preferable, and 3,000 or more is further preferable. Further, when the mass-average molecular weight is 30,000 or less, excellent curability is obtained, and 10,000 or less is more prefarable, and 5,000 or less is futher preferable. The mass-average molecular weight can be measured by gel permeation chromatography (GPC) (standard polystyrene conversion).

In some embodiments, the maleimide resin exist in an amount of 2 to 98 percent by mass in the total mass of the resin component in the film. Further, when the amount of maleimide resin is 50 percent by mass or more in the resin component that composes the film, it is preferably from the view point of excellent reactivity and resistance to thermal degredation.

### <Initiator>

At least one curing initiator typically exists in the composition at an amount of 0.1 percent by mass to 5 percent by mass of the total amount of resin component in the film, and is typically a radical initiator. A radical initiator is a species that functions as a reactive substance at the initiating step of the radical chain reaction, but does not participate in the arbitrary propagating step. In the present description, it refers to an arbitrary chemical species that is not electrically charged when exposed to enough energy (for example, light, heat, or those of similar type), but decomposes into two parts with at least one unpaired electron. As the radical initiator, for example, azo-compounds, peroxides, hydrocarbon radical initiators may be listed. Hydrocarbon radical initiators are disclosed in, for example, JP-A-2009-203384, and is preferable in that the cured resin composition shows excellent electric property. The radical initiator that is used in performing the present invention has a one-hour half-life temperature of 200°C or higher. Further, the maximum one-hour half-life temperature of the radical initiator is not particularly limited, but is preferably 250°C or lower. When the one-hour half-life temperature of the radical initiator is 200°C or higher, it is preferable in that the film obtained will show high preserving property. Examples of radical initiators are 3,4-di-t-butyl-2,2,5,5-tetrarnethylhexane, di-tert-amyl peroxide, di-t-butylperoxide, 3,6,9-triethyl-3,6,9-trimethyl-1,4,7-triperoxonane, 2,5-dimethyl-2,5-di(t-butylperoxy)hexyne-3, p-methane hydroperoxide, isopropylcumyl hydroperoxide, 1,1,3,3-tetramethylbutyl hydroperoxide, 2,4,5,7-tetramethyl-4,5-diphenyloctane, diisopropylbenzene hydroperoxide, tert-amyl hydroperoxide, cumene hydroperoxide, 4,5-dimethyl-4,5-diphenyloctane, t-butyl hydroperoxide, 3,4-dimethyl-3,4-diphenylhexane, 2,3-dimethyl-2,3-diphenylbutane may be listed.

The radical initiator may further include photoinitiators. For example, the adhesive composition of the present invention that contains a photoinitiator may initiate the curing process by UV irradiation. In one embodiment, the photoinitiator may exist in a concentration of 0.1 percent by mass to 5 percent by mass based on the total mass of the resin component in the film. In one embodiment, the photoinitiator may exist in a concentration of 0.1 percent by mass to 3 percent by mass based on the total mass of the resin component in the film. As the photoinitiator, benzoin derivatives, benzyl ketals, alpha, alpha-dialkoxyacetophenones, alphaaminoalkylphenones, acylphosphineoxides, titanocene compounds, combinations of benzophenones and amine or Michler's ketone, and similar compounds are included.

### <Polymer Component>

In the present invention, a polymer component may be included to facilitate film formation. Further, the polymer component may further contribute to the stress-relaxation property. The polymer component may be any type as long as it is easy to handle and shows compatibility with the maleimide resin. Examples of favorable resins are thermoplastic resins that are hydrophobic and soluble to toluene. When the polymer component shows compatibility with the maleimide resin, the thermoplastic resin and the maleimide resin is most-likely soluble to the same solvent, and as such solvent, an aromatic solvent may be exemplified. Examples of usable solvents are toluene and xylene.

As a thermoplastic resin that is hydrophobic and soluble to toluene, for example, a styrene-butadiene block copolymer, a styrene-isoprene block copolymer, a block copolymer of a mixture of styrene butadiene isoprene, may be listed. The block copolymer of styrene and butadiene that is useful in the present invention may be a di-block copolymer, which contains a styrene polymer segment and a butadiene polymer segment that are covalently bonded to each other. The block copolymer of styrene and butadiene that is useful in the present invention may also be a tri-block copolymer, which contains two segments of styrene polymer and one segment of butadiene polymer, wherein each of the styrene polymer segments are covalently bonded with the butadiene polymer segment. Another block copolymer of styrene and butadiene that is useful in the present invention may be a block copolymer of styrene and butadiene wherein the butadiene segment is hydrogenated. Further, it may be a tri-block copolymer that contains a styrene polymer segment, a butadiene polymer segment, and a methacrylate ester polymer segment. Other than styrene block copolymers, polyimide precursors such as polyamic acids, polyamic acid esters, and polyamic acid amides, poly-THF, carboxy-terminal butadiene-acrylonitrile rubber, and polypropylene glycol, are favorable. Further, any polymer component of phenoxy, acrylic rubber, polyimide, polyamide, polyacrylate, polyether, polysulfone, polyethylene, polypropylene, polysiloxane, polyvinyl acetate/polyvinyl ester, polyolefin, polycyanoacrylate, which show compatibility with the maleimide resin, may be suitably used. Furthermore, thermoplastic resins that contain polymer segments equipped with reactive double bonds are capable of reacting with the maleimide resin during the curing process activated by the radical.

When the mass-average molecular weight of the polymer component is 10,000 or more, excellent film formation easiness is obtained. Further, when the mass-average molecular weight is 1,000,000 or less, excellent flowability during affixation of the film with the adherend is obtained. A mass-average molecular weight of 200,000 or less is more preferable, and that of 100,000 or less is further preferable. The mass-average molecular weight can be measured by gel permeation chromatography (GPC) (standard polystyrene conversion). In a specific embodiment, when the compounding ratio of the polymer component is 5 percent by mass or more based on the total mass of the resin component in the film, excellent film formation easiness is obtained. Further, when the compounding ratio of the polymer component is 50 percent by mass or less, excellent flowability during affixation of the film with the adherend is obtained. A compounding ratio of 40 percent by mass or less is more preferable, and 30 percent by mass or less is further preferable.

### <Other Components>

In the present invention, curable components other than the maleimide resin may be included. The curable component is not particularly limited, but those with an ethylenically unsaturated group in the molecule may be preferably used. For example, (meth)acrylate compounds having an amide bond in the molecule, bisphenol A-type (meth)acrylate, compounds obtained by reacting α, β-unsaturated carboxylic acids to polyhydric alcohols, compounds obtained by reacting α, β-unsaturated carboxylic acids to glycidyl-group-containing compounds, urethane monomers or urethane oligomers such as (meth)acrylate compounds having urethane bonds within the molecule, etc. may be listed. Other than these, nonylphenoxypolyoxy ethylene acrylate, phthalic acid-type compounds such as γ-chloro-β-hydroxypropyl-β'-(meth)acryloyloxyethyl-o-phthalate and β-hydroxyalkyl-β'-(meth)acryloyloxyalkyl-o-phthalate, (meth)acrylic acid alkyl ester, EO-modified nonylphenyl(meth)acrylate, etc., may be exemplified. In one embodiment, a compound containing isocyanulate ring may be used. In another embodiment, a compound having a tetrahydrofuran structure may be used. These compounds may be used singularly or two or more types may be used in combination. In a specific embodiment, when the compounding ratio of the curable component other than the maleimide resin is 2 percent by mass or more based on the total mass of the resin component in the film, it is excellent from the view point of flowability during affixation of the film with the adherend and improvement of curability, and further, 5 percent by mass or more is more preferable. Further, from the view point of thermal stability of the film, 50 percent by mass or lower is preferable, 30 percent by mass or lower is further preferable, and 10 percent by mass or lower is yet further preferable.

In the present invention, a coupling agent may be added. In the present invention, the coupling agent facilitates the bonding between the maleimide film and the adherend. As the coupling agent, one that is compatible with the other components of the present invention may be used. Further, those that participate in radical curing reaction may be used. For example, mercaptosilane-type, acryl-type, γ-mercaptopropyltrimethoxy silane, γ-methacryloxy propyltrimethoxy silane, γ-aminopropyltrimethoxy silane, and vinyltrimethoxy silane may be listed. Silicate esters, metal acrylate salts (for example, aluminum(meth)acrylate), titanate (for example, titanium(meth)acryloxyethylacetoacetate triisopropoxide), or a compound that contains a copolymerizable group and a chilating ligand (for example, phosphine, mercaptan, acetoacetate and others of the same type) may be listed. In several embodiments, the coupling agent contains both a copolymerizable functional group (for example, vinyl group, acrylate group, methacrylate group, and those of the same type) and a silicate ester functional group. When the adherend or the later-described filler is a metal, the silicate ester part of the coupling agent can undergo condensation with the metal hydroxide on its surface. On the other hand, the copolymerizable functional group can undergo copolymerization with the other reactable components of the adhesive film of the present invention. In a particular embodiment, the coupling agent that may be used to perform the present invention is an oligomer silicate coupling agent such as poly(methoxyvinylsiloxane). The coupling agent may be added in the range of 0.1 percent by mass to 5 percent by mass based on the total mass of the resin component in the film.

The present invention may contain a filler. By adding a filler, functions according to the filler may be added to the maleimide film. On the other hand, when a filler is not added, the film may be superior in terms of high flowability. The filler may be any generally known filler, and may be an organic filler, an inorganic filler, or a metallic filler. Organic fillers are favorable in that they can add toughness to the film, and fillers such as acryl, polyimide, polyamideimide, polyetheretherketone, polyetherimide, polyesterimide, nylon, and silicone may be listed. Inorganic fillers and metallic fillers can improve handling property, improve thermal conductivity, add electric conductivity, control melt viscosity, and improve addition of thixotropic property. The metallic fillers are not particularly limited and may be, for example, gold, silver, copper, aluminum, iron, indium, tin, and alloys thereof. Inorganic fillers are not particularly limited, and may be, for example, aluminum hydroxide, magnesium hydroxide, calcium carbonate, magnesium carbonate, calcium silicate, magnesium silicate, calcium oxide, magnesium oxide, alumina, aluminum nitride, aluminum borate whisker, boron nitride, crystalline silica, and amorphous silica. The form of the filler is not particularly limited. Such fillers may be used singularly or two or more types may be used in combination.

For the purpose of controlling melt viscosity and adding thermal resistance, alumina, silica, aluminum hydroxide etc. are preferable, and silica is more preferable for its versatility. The silica is preferably spherical silica, since it enables the formation of thin maleimide films, and because it enables adding the filler in high ratio.

The specific surface area of the silica filler is preferably 70 to 150 m²/g, and more preferably 100-130 m²/g. When the specific surface area of the silica filler is 70 to 150 m²/g it is advantageous in that a small amount can improve the heat resistance. In another embodiment, the specific surface area of the silica filler is preferably 3 to 12 m²/g, and more preferably 5 to 10 m²/g. When the specific surface area of the silica filler is 3 to 12 m²/g it is advantageous in that the filler can be added at a high ratio in the maleimide film.

Further, the average particle size of the silica filler is preferably 0.01 to 0.05 µm, since a small amount can improve the heat resistance, and more preferably 0.012 to 0.03 µm. It is especially preferable that the average particle size is 0.014 to 0.02 µm. In another embodiment, the average particle size of the silica filler is preferably 0.2 to 1 µm, since the filler can be added at a high ratio, and more preferably 0.3 to 0.8 µm. It is especially preferable that the average particle size is 0.4 to 0.6 µm. When adding multiple types of silica filler, it is preferable that the average particle size of at least one type of silica filler is 0.2 to 1 µm.

The rate of content of the silica filler is preferably 5 to 70 percent by mass based on the total mass of the film, since the heat resistance of the maleimide film can be improved while maintaining flowability at the same time. Further, in relation to the average particle size, for silica filler with an average particle size of 0.01 to 0.05 µm, the rate of content is preferably 5 to 15 percent by mass based on the total mass of the film; for silica filler with an average particle size of 0.2 to 1 µm, the rate of content is preferably 10 to 70 percent by mass based on the total mass of the film, or more preferably 20 to 60 percent by mass based on the total mass of the film; in such cases, the heat resistance of the maleimide film is improved while maintaining flowability at the same time.

In another embodiment, when a filler with a thermal conductivity of 20 W/m.K or more is applied, it is preferable in that the thermal conductivity is improved. It is more preferable that the thermal conductivity is 30 W/m.K or more, and from the view point of securing high thermal conductivity with a small filler content, it is further preferable that the thermal conductivity is 100 W/m.K or more. The thermal conductivity of the filler refers to the value calculated by first, measuring the thermal diffusivity by the laser flash method (for example, measurement condition: laser pulse width of 0.4 ms, laser wave-length 1.06 µm; measurement apparatus: TC7000, product of ULVAC, Inc.), then multiplying the obtained value with the filler's density and specific heat. As such filler, for example, gold (320 W/m.K), silver (420 W/m.K), copper (84 W/m.K), aluminum (236 W/m.K), iron (84 W/m.K), indium (84 W/m.K), tin (64 W/m.K), alumina (Al2O3, 30 W/m.K), aluminum nitride (AlN, 260 W/m.K), boron nitride (BN, 275 W/m.K (in-plane direction)), silicon nitride (Si3N4, 23 W/m.K) are listed. However, the filler is not limited to these examples.

From the view point of having excellent thermal conductivity, metallic fillers or aluminum nitride are preferable, and from the view point of excellent thermal conductivity and electric insulation, aluminum nitride and alumina are preferable. One type may be used singularly or two or more types may be used in combination. By using a filler with a relatively small average particle size of, for example, 0.1 to 2 µm, or more preferably, 0.2 to 1.8 µm, in combination with a filler with a relatively large average particle size of, for example, 2 to 10 µm, or more preferably, 2.5 to 9.5 µm, the thermal conduction path between the fillers with large average particle size is connected by the fillers with small average particle size. Thus, compared to the case where fillers of the same average particle size is used, high filling becomes possible, which often leads to higher thermal conductivity. In this case, the filler with a small average particle size and the filler with a large average particle size is preferably used in a mass ratio of 1 : 0.1 to 1.0, for the formation of thermal conduction path. In general, when the average particle size is excessively large, the surface profile of the hardened material worsens, and when the average particle size is excessively small, aggregation tends to occur, causing dispersibility to worsen. Thus, for a granular filler, it is preferable to use one with an average particle size of about 0.05 to 10 µm. Further, for an aggregated filler, it is preferable to use one with an average crystal size of 10 to 5000 nm and an average aggregate size of 1 to 1000 µm.

The content of the filler with a thermal conductivity of 20 W/m+K or more is preferably 30 percent by volume or more of the film, since the thermal conductivity improves, and is more preferably 40 percent by volume or more. Further, the content of the filler with a thermal conductivity of 20 W/m.K or more is preferably 70 percent by volume or less, since excellent film-formation is obtained, and is more preferably 60 percent by volume or less.

Further, in another embodiment, from the view point of improving conductivity, a conductive filler may be added. As such fillers, for example, carbon particles, metallic particles such as silver, copper, nickel, aluminum, gold, tin, zinc, platinum, palladium, iron, tungsten, or molybdenum, alloys thereof, solder particle, particles prepared by subjecting to surface lining or coating with a conductive coating agent such as metal or alloy, may be listed, but are not limited to these.

As particles that are coated on the surface with a conductive coating, conductive particles different from the coating agent may be used or, as non-conductive particles, particles comprising, for example, polyethylene, polystyrene, phenol resin, epoxy resin, acrylic resin or benzoguanamine resin, or glass beads, silica, ceramics etc., may be listed. One type may be used singularly or two or more types may be used in combination.

As an alloy, the melting point is preferably 200 °C or lower, since the fillers melt and fuse in the curing process of the maleimide film, leading to higher conductivity. Specifically, Sn42-Bi58 solder (melting point 138 °C), Sn48-In52 solder (melting point 117 °C), Sn42-Bi57-Ag1 solder (melting point 139 °C), Sn90-Ag2-Cu0.5-Bi7.5 solder (melting point 189 °C), Sn89-Zn8-Bi3 solder (melting point 190 °C), Sn91-Zn9 solder (melting point 197 °C) etc., are listed. In particular, alloys with melting points of 180 °C or lower are preferable. Further, alloys that contain Sn are preferable in that they are easy to adjust the melting point to 200 °C or lower, and alloys of Si and Bi are more preferable. Alloys of Si and Bi with an alloy ratio of Sn:Bi=79:21 to 42:48 are especially preferable, since they show eutectic melting point.

Such conductive filler is preferably one that is capable of forming a sintered compact, since increasing electroconductivity and stronger bonding is enabled. Sintering is a phenomenon wherein particles in a state of contact are maintained at a temperature below its melting point to let the bonding of particles proceed in the direction of decreasing the surface energy of the entire particle system, to thereby densify the particle system. In one embodiment, the (C) filler contains a metal nanofiller, or consists solely of a metal nanofiller, to accelerate sintering. That is, by having fillers of smaller particle size, the total surface area per unit mass increases drastically, causing the contribution of the surface energy to increase. Thus, the amount of thermal energy necessary for melting decreases, allowing sintering at lower temperatures. As such fillers, silver particle, copper particle, or mixtures thereof may be used, and may be prepared by methods described, for example, in JP-A-2005-146408 and JP-A-2012-082516.

In another embodiment, a combination of two or more fillers that undergo transitive liquid phase sintering may be utilized. Liquid phase sintering refers to a special form of sintering in which solid powder particle coexist with the liquid phase. In liquid phase sintering, the metals are diffused within each other to form a new alloy and/or intermetallic body. Thus, the mixture becomes densified and homogenized. In transitive liquid phase sintering, as a result of the homogenization of the metal, the time in which it exists in the liquid phase becomes extremely short. That is, the liquid phase has an extremely high solubility in the surrounding solid phase, and thus, quickly diffuses in the solid, finally leading to solidification. By diffusion homogenizing, heating above the equilibrium melting temperature of the metal particle mixture becomes unnecessary to obtain the final composition.

For example, as the combination that shows superior conductivity, copper-indium-type alloy, copper-tin-type alloy, silver-indium-type alloy, silver-tin-type alloy, gold-indium-type alloy, gold-tin-type alloy, and gold-lead-type alloy may be listed, but the combination is not limited to these examples. All systems including In show an eutectic point around 150 °C, and are superior in that low-temperature sintering proceed smoothly. Further, systems including Sn show an eutectic point around 200 °C, and are preferable from the view point of heat resistance reliability.

Such conductive filler may be spherical, non-spherical, branch-like, flake, plate-like, porous, etc. The average particle size of the filler is preferably 30 µm or smaller, since it becomes easier to make the maleimide film thin and a particle size of 10 µm or smaller is further preferable. When the particle size is 5 µm or smaller, it is preferable, since the surface area increases and the particles become more wettable. At a particle size of 1 µm or less, the total surface area per unit mass increases drastically, causing the contribution of the surface energy to increase. Thus, it is preferable in that the amount of thermal energy necessary for melting decreases and sintering at lower temperatures become possible.

Further, the average particle size of a filler is generally 0.005 µm or more. An average particle size of 0.1 µm or more is preferable, since aggregation is less likely to occur, and dispersibility in solvent and resin is enhanced. Further, in order to increase the contact points between the fillers, the amount of the filler is preferably 75 percent by mass or more of the total mass of the solid content of the conductive adhesive composition, and more preferably, 85 percent by mass or more, and further preferably, 90 percent by mass or more. Further, in order to provide an effect of dispersion by solvent and resin and an assisting effect of adherence, the amount of the filler is preferably 99 percent by mass or less of the total mass of the solid content of the conductive adhesive composition, and more preferably, 98 percent by mass or less.

When the filler is conductive, it is preferable that the maleimide film contains a flux. The flux is useful in removing the surface oxide film on the conductive filler.

As the flux, any compound may be used without particular limitation, as long as the compound does not hinder the curing reaction of the maleimide resin and other curable resins. For example, polyhydric alcohols, carboxylic acids, inorganic acids, alkanolamines, phenols, rosins, chloride compounds and their salts, halide compounds and their salts etc. may be listed. In a specific embodiment, the flux is composed of a salt or mixture of carboxylic acid and tertiary amine, and may be of potentiality. In another embodiment, the flux may be inactivated at the completion of the heat treatment of the maleimide film, in which case, it is inactivated by insertion through the reaction between the functional group of the flux and the curable resin.

As the aforementioned carboxylic acid, for example, acrylic acid, methacrylic acid, maleic acid, fumaric acid, valeric acid, hexanoic acid, heptanoic acid, 2-ethylhexanoic acid, octanoic acid, 2-methyl heptanoic acid, 4-methyl octanoic acid, nonanoic acid, decanoic acid, neodecanoic acid, dodecanoic acid, tetradecanoic acid, lauric acid, myristic acid, palmitic acid, stearic acid, oleic acid, linoleic acid, linolenic acid, lactic acid, malic acid, citric acid, benzoic acid, phthalic acid, isophthalic acid, oxalic acid, malonic acid, succinic acid, glutaric acid, adipic acid, pyruvic acid, butyric acid, pivalic acid, 2,2-dimethyl butyrate, 3,3-dimethyl butyrate, 2,2-dimethyl valerate, 2,2-diethyl butyrate, 3,3-diethyl butyrate, naphthenic acid, cyclohexanedicarboxylic acid, 2-acryloyloxyethyl succinate, 2-methacryloyloxyethyl succinate, 2-acryloyloxyethyl hexahydro phthalate, 2-methacryloyloxyethyl hexahydro phthalate, 2-acryloyloxyethyl phthalate, 2-methacryloyloxyethyl phthalate, etc. may be listed. One may be used or two or more carboxylic acids may be used in combination.

In a particular embodiment, the molecular weight of the carboxylic acid is 150 to 300. By having carboxylic acid with a molecular weight of 150 to 300, abnormal increase in viscosity when applying the conductive adhesive composition can be prevented, and the bonding of the conductive particles can be encouraged. In another embodiment, dicarboxylic acid are preferable. As such dicarboxylic acid, oxalic acid, malonic acid, succinic acid, glutaric acid, fumaric acid, maleic acid etc. may be listed. The tertiary amine is used as a mixture or salt with acidic functional groups, and forms a buffer solution or salt with the acidic functional group of the carboxylic acid, in order to prevent excessively rapid reaction with other organic components. The tertiary amine may be a monomer, oligomer, or polymer combined with one or more compound. As tertiary alkanolamines such as triethanolamine and N,N,N, N,N,N',N'-tetrakis (2-hydroxyethyl) ethylenediamine may be listed, and are suitable in forming buffer mixtures or salts with the carboxylic acidic functional group.

The flux may be introduced to the maleimide film of the present invention in various different forms. For example, in a state of compatibility in the resin, in a state of mixture as a particle, in a state of being coated on the conductive filler, etc., may be listed. The average particle size of the flux in particle form is 30 µm or smaller, and is preferably 15 µm or smaller. By having an average particle size of 15 µm or smaller, the metal becomes easier to melt. It is speculated that by having a smaller average particle size, the apparent melting point of the flux decreases, making it easier to melt, thereby making it easier to remove the oxide film. Further, from the view point of enabling thin film application of the maleimide film, the average particle size is preferably 10 µm or smaller, and more preferably, 6 µm or smaller. From the view point of enhancing printability of the conductive adhesive composition, it is preferably 2 µm or smaller. Further, from the view point of operability, thin film application, and printability, the average particle size is preferably 0.01 µm or larger. Here, the term thin film implies a thickness of 20 µm or thinner. Good applicability refers to a state in which the line width is even when applying the conductive adhesive composition by, for example, a dispenser, to draw a line, and a state in which the surface roughness is within 10% of the film thickness when a film is formed by a coater. Further, printability refers to a state in which the paste viscosity on the target does not increase with time when printed continuously by, for example, screen printing.

Note that the term "average particle size" used in the present specification refers to the D50 value of the cumulative volume distribution curve, in which the 50 volume% particle measured by the laser diffraction method has a smaller diameter than this value. The laser diffraction method is preferably performed using the Malvern Mastersizer 2000 of Malvern Instruments Ltd. In this technology, the size of the particle in a suspension or emulsion is measured by the diffraction of laser beam, based on the application of the Fraunhofer or Mie theory. In the present invention, the Mie theory or the modified Mie theory for non-spherical particle is used, and the average particle size or D50 value is related to the scattering measurement at 0.02 to 135° against the incident laser beam. Further, when it is difficult to measure by the laser diffraction method, the particle size was determined from the diameter of a circle, whose area is about the measured value of the sectional area of the particle from the electron microscope image obtained using a scanning electron microscope (SEM).

As a method of adjusting the average particle size of the flux, a method of pulverizing is exemplified. As a method of pulverization, a grinder may be utilized. As for the types of grinder, those known, such as ball mill grinders, jet mill grinders, ultra fine powder grinders, hammer-type grinders, mortars, roller mills, etc., may be listed. Note that the method of adjusting average particle size is not limited to these examples.

In another embodiment, the conductive adhesive composition of the present invention may further include one or more additive such as a plasticizer, an oil, a stabilizer, an antioxidant, a corrosion preventative, an inhibitor, a chelating agent, a pigment, a dye, a polymer additive, a defoaming agent, a preservative, a thickener, a rheology-adjusting agent, a moisturizing agent, a tackifier, a dispersant, and water.

### <Maleimide Film>

The maleimide film may be produced by ordinary methods. For example, after preparing a varnish containing the maleimide resin, the varnish may be applied on a cover film at a certain thickness to form a coated membrane; by drying the coated membrane under a certain condition, the maleimide film may be produced. The method of application is not particularly limited, and for example, roll coating, screen coating, and gravure coating etc. may be listed. Further, as the drying condition, for example, drying may be performed at a temperature of 80 to 130°C for a time range of 1 to 5 minutes. As the cover film, a plastic film such as polyethylene-terephthalate (PET), polyethylene or polypropylene, or film or paper is coated with a peeling agent such as fluorine-type peeling agent, and long-chain alkylacrylate-type peeling agent, may be used. It is preferable to form a film using such methods, since the thickness between the adherends may be maintained and handling becomes easy. To form a film with the conductive adhesive composition, a maleimide resin with a molecular weight of 1000 or more is applied. Further, it is preferable that the composition contains a polymer component.

The thickness of the adhesive film is not particularly limited, but may preferably be 1 to 300 µm. When adhering two layers of adherends, the thickness is preferably 5 to 60 µm, and when stress-relaxation is required, the thickness is preferably 60 to 200 µm.

Further, by combining the maleimide film with a dicing tape in the form of a laminate, the adhesive film may be used favorably as an adhesive film with a dicing tape. A dicing tape is a tape that is used mainly in the process of cutting wafer by dicing saw and dicing integrated circuits and packages formed on a semiconductor wafer.

### <Dicing Tape>

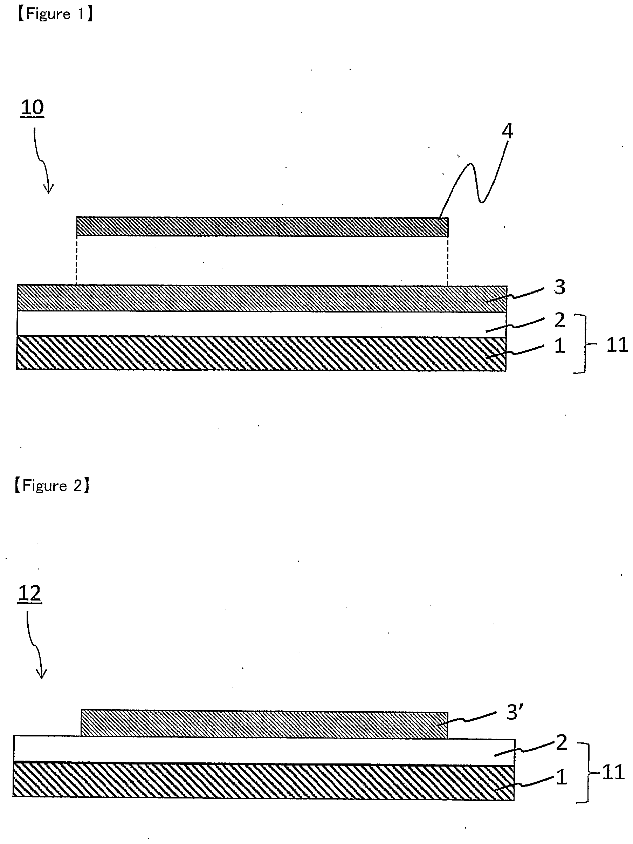

FIG 1 and FIG 2 are schematic diagrams that show the sectional views of one embodiment of the adhesive film with dicing tape of the present invention.

In FIG 1, the structure of the adhesive film with dicing tape 10, in which the adhesive film 3 is laminated on the dicing tape 11, is shown. The dicing tape 11 is composed of a pressure-sensitive adhesive layer 2 laminated on a substrate 1, and the adhesive film 3 is provided on top of the adhesive layer 2. As shown in the adhesive film with dicing tape 12 of FIG 2, the adhesive film 3' may be formed only on the work-sticking part.

The substrate 1 is the strength matrix of the adhesive film with dicing tape 10, 12 and preferably shows ultraviolet transmission property and expandability when expanded. For example, polyolefins such as polyethylene, polypropylene, polybutene, and polymethylpentene, ethylene-vinyl acetate copolymer, ionomer resin, ethylene-(meth)acrylic acid copolymer, ethylene-(meth)acrylic acid ester (random, alternating) copolymer, ethylene-butene copolymer, ethylene-hexene copolymer, polyurethane, polyesters such as polyethylene terephthalate and polyethylene naphthalate,, polycarbonate, polyimide, polyether ether ketone, polyether imide, wholly aromatic polyamide, polyphenylsulfide, aramid (paper), glass, glass cloth, fluorine resin, polyvinylchloride, polyvinylidenechloride, cellulose-type resin, silicone resin, crosslinked bodies of the aforementioned resins, metal (foil), paper etc. can be listed.

In order to enhance adhesion, retention, etc., the surface of the substrate 1 may be subjected to conventional surface treatments such as various chemical and physical treatments like chromic acid treatment, ozone exposure, flame exposure, high voltage lightening exposure, ionizing radiation treatment, coating treatment using primers (such as the later-described adhesive substance).

As the substrate, the same or different materials may be arbitrarily selected and used, and several types may be blended and used as necessary. Further, different types may be layered and used.

The thickness of substrate 1 is not particularly limited, but may generally be about 50 to 200 µm.

The adhesive material to be used in the pressure-sensitive adhesive layer 2 is not particularly limited, and general pressure-sensitive adhesive such as acrylic-type adhesive and rubber-type adhesive.

As the adhesive material used to form the pressure-sensitive adhesive layer 2, radiation-curable resins may also be used. The adhesive strength of radiation-curable resins may easily be reduced by irradiation of radiation such as ultraviolet ray to increase the degree of crosslinking.

As the radiation-curable adhesive agent, those having radiation curable functional groups such as carbon-carbon double bonds that also show adhesiveness may be used without particular limitation. For example, addition-type radiation-curable adhesive agents obtained by combining radiation-curable monomer components and oligomer components to general pressure-sensitive adhesive agents such as the aforementioned acrylic-type adhesive agent and rubber-type adhesive agent may be exemplified.

As the radiation-curable monomer component to be combined, for example, urethane oligomer, urethane(meth)acrylate, trimethylol propane tri(meth)acrylate, tetramethylol methane tetra(meth)acrylate, pentaerythritol tri(meth)acrylate, pentaerythritol tetra(meth)acrylate, dipentaerythritol monohydroxy penta(meth)acrylate, dipentaerythritol hexa(meth)acrylate, 1,4-butanediol di(meth)acrylate etc. may be listed. Further, as the radiation-curable oligomer component, various oligomers such as urethane-type, polyether-type, polyester-type, polycarbonate-type, polybutadiene-type may be listed, and those with a molecular weight in the range of 100 to 30000 are suitable. The amount of radiation-curable monomer components and oligomer components may be determined arbitrarily according to the type of the adhesive layer. In general, the amount is, for example, 5 to 500 parts by mass, or more preferably, 40 to 150 parts by mass, based on 100 parts by mass of the base polymer such as the acrylic polymer composing the adhesive layer.

Further, as the radiation-curable adhesive agent, other than the aforementioned addition-type radiation-curable adhesive agent, endogenous-type radiation-curable adhesive agents that have carbon-carbon double bonds on the polymer side chain, main chain, or end of the main chain may be listed as the base polymer. Such endogenous-type radiation-curable adhesive agents do not require the addition of oligomer components etc., or do not contain many. Thus, they are preferable since chronological migration of the oligomer components within the adhesive agent does not occur, and an adhesive layer with a stable layer structure can be formed.

Further, as the radiation-curable adhesive agent, for example, an addition polymerizable compound having two or more unsaturated bonds as disclosed in JP-A-S60-196956, rubber-type adhesive agents and acrylic-type adhesive agents containing a photo-polymerizable compound that has an epoxy group such as alkoxysilane and a photopolymerization initiator such as carbonyl compounds, organic sulfur compounds, peroxides, amines, onium salt-type compounds may be listed.

The thickness of the pressure-sensitive adhesive layer 2 is not particularly limited, but is preferably about 1 to 50 µm. Preferably, the thickness is 2 to 30 µm, or further preferably, 5 to 25 µm.

FIG 1 shows a concise example of the structure and method for producing a semiconductor device using such an adhesive film with dicing tape.

More specifically, on the semiconductor wafer sticking part of the adhesive film 3 of the adhesive film with dicing film 10, a semiconductor wafer 4 is pressure bonded, and fixed by adhesion holding (adhesion process). This process is performed by a pressurizing means such as a pressurizing roll.

### <Method for Producing Semiconductor Device>

Next, as a method of using the maleimide film of the present invention, an example of the method for producing semiconductor device using the maleimide will be described.

### (Adherend)

The maleimide film of the present invention can bond semiconductor chips, semiconductor and support member, or support member and functional members such as a heat dissipation member. Such adherend preferably has a surface that is coated with metal or membrane of polyimide. As the metal on the surface of the adherend, gold, silver, copper, nickel etc., may be listed. Further, amond these, a plurality of materials may be patterned on the substrate.

### (Production Process)

The method for producing semiconductor device by connecting semiconductor chip with a support member comprises the following processes.
(A) A process of applying the maleimide film to the semiconductor chip or support member, to bond the semiconductor chip and the support member together. (Hereinafter, referred to as "process (A)".)
(B) A process of heating the maleimide film, to thereby bond the semiconductor chip with the support member. (Hereinafter, referred to as "process (B)".)

### (Process (A)) -process of applying the maleimide film-

The maleimide film is applied by sticking to a support member or a semiconductor chip. In this process, to a chip that has already been divided, a film of the same size may be stuck or the maleimide film may be stuck in the form of a semiconductor wafer and then diced. It is preferable to use the maleimide film in the form of the aforementioned adhesive film with dicing tape for the process of dividing the wafer into chips, since the process becomes simple. The wafer may also be divided into chips after the maleimide film and dicing tape are stuck to the semiconductor wafer separately.

### (Process (B)) -connection process-

Subsequently, heat-treatment is performed on the maleimide film. It may be a simple heat-treatment or a pressurized heat-treatment. For the heat-treatment, a hot plate, a hot-air dryer, a hot-air furnace, a nitrogen dryer, an infrared dryer, an infrared furnace, a far infrared furnace, a microwave heating device, a laser heating device, an electromagnetic heating device, a heater heating device, a steam furnace, etc. may be used. Further, for the pressurized heat-treatment, a hot-plate pressurizing device may be used, or the aforementioned heat-treatment may be performed while adding pressure by a weight.

When the maleimide film contains a filler, by subjecting to heat-treatment, the filler in the maleimide film also melts and bonds. In the bonding of the filler, bonding between the filler and the adherend, or the filler and the metal on the surface of the adherend, proceed along with alloying; not just the bonding between fillers. Thus, it is preferable, since interfacial failure becomes less likely to occur, and the preventative effect of peeling and destruction due to difference in linear expansion within the device is enhanced.

By the above-described production method, a semiconductor device in which the semiconductor chip and the support member are bound by the conductive adhesive composition of the present invention can be produced.

### <Semiconductor Device>

The semiconductor device may be used in power modules comprising a diode, a rectifier, a thyristor, a MOS gate driver, a power switch, a power MOSFET, IGBT, short-key diode, fast recovery diode, etc., a transmitter, an amplifier, a LED module, a battery module, etc. The module obtained shows high adhesive property between the adherends and can show thermal conductivity, electric conductivity, and heat resistance,

### EXAMPLE

Hereinafter, the present invention will be described more specifically with reference to the following Examples. However, the present invention is not limited in anyway by these Examples.

A varnish obtained by blending the components shown in Table 1 and a suitable amount of toluene was applied on a cover tape comprising a PET film of 50 µm thickness, and passed through a drying furnace at 140 °C for 5 minutes, to form the adhesive films of Examples 1 to 12 and Comparative Examples 1 to 3 each with a thickness of 30 µm.

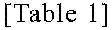

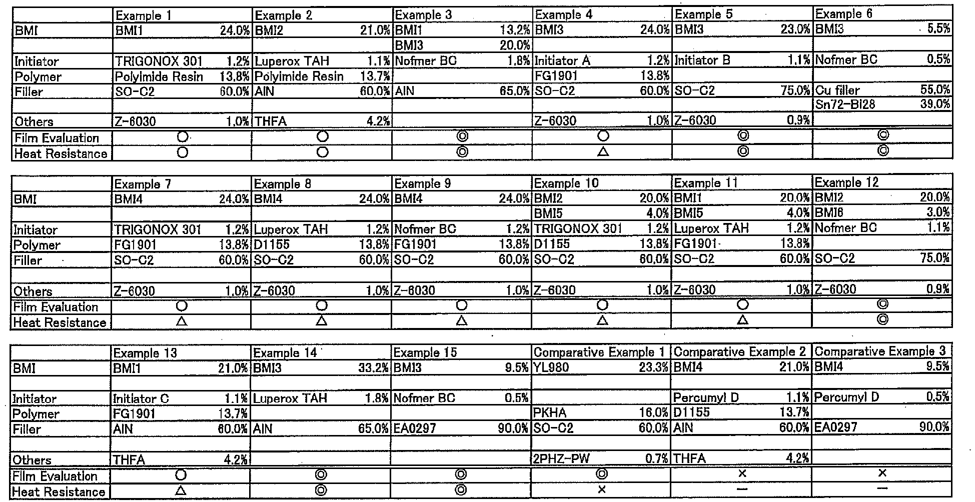

### BMI1: a structure that satisfies the following formula (18) (n= 1 to 10)

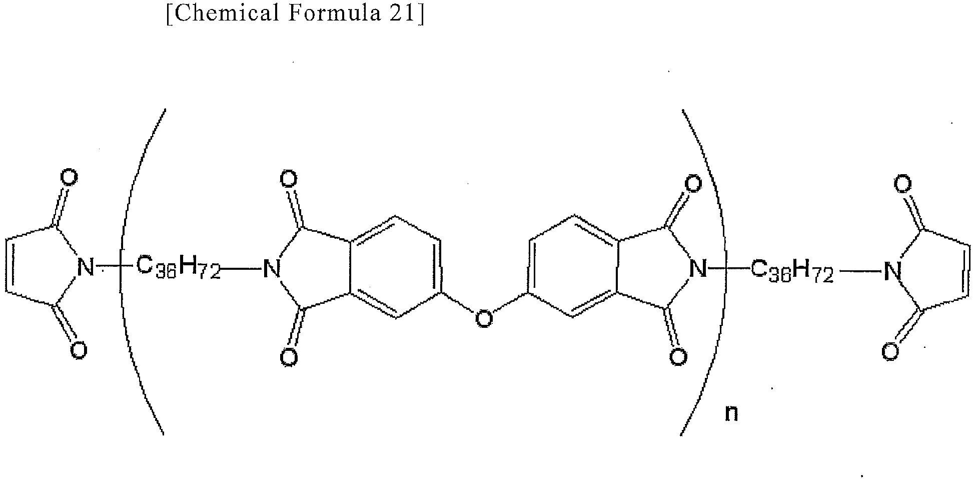

### BMI2: a structure that satisfies the following formula (19)

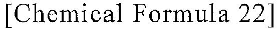

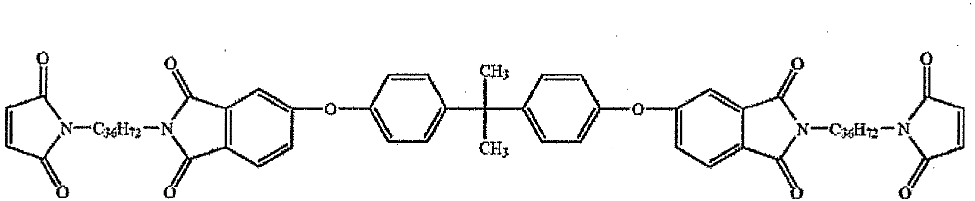

### BMI3: a structure that satisfies the following formula (20) (n=1 to30), gel form

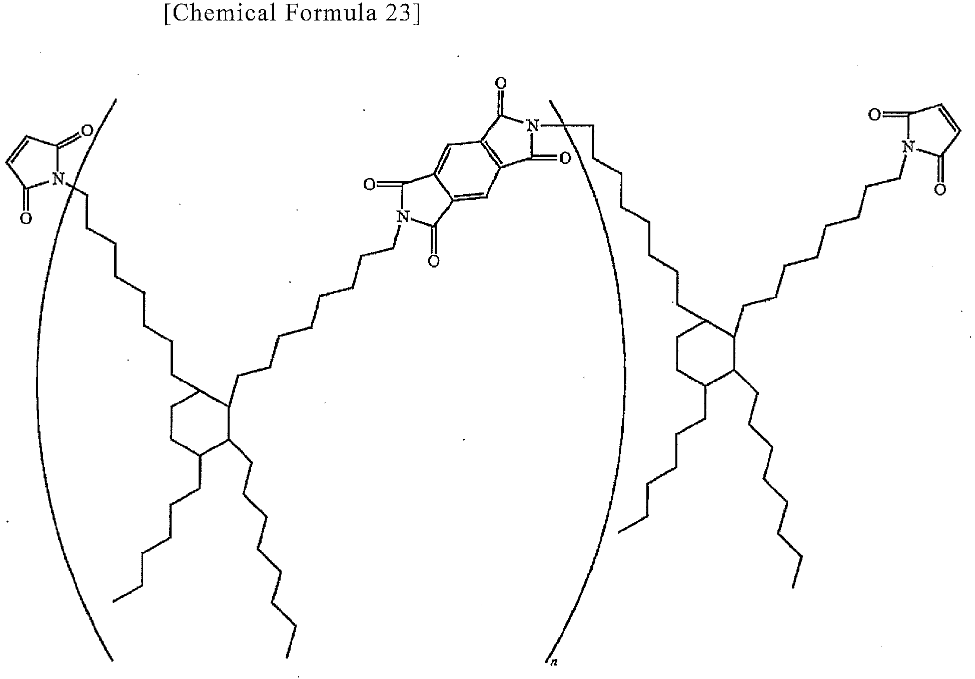

### BMI4: a structure that satisfies the following formula (21)

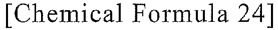

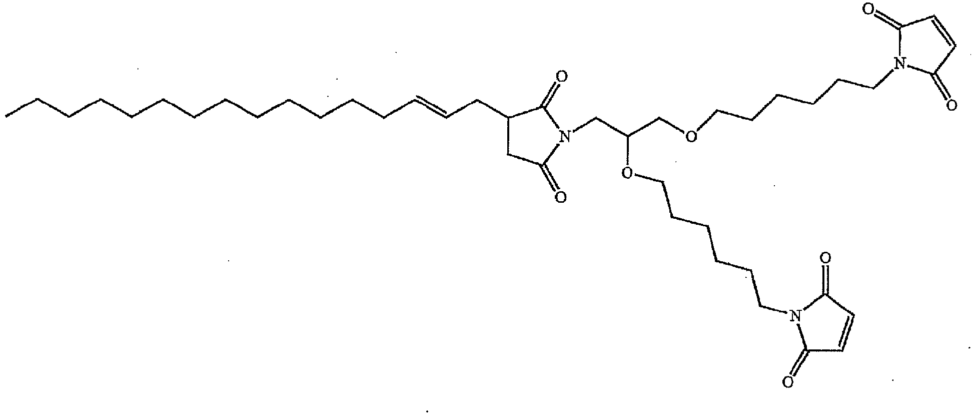

### BMI5: a structure that satisfies the following formula (22)

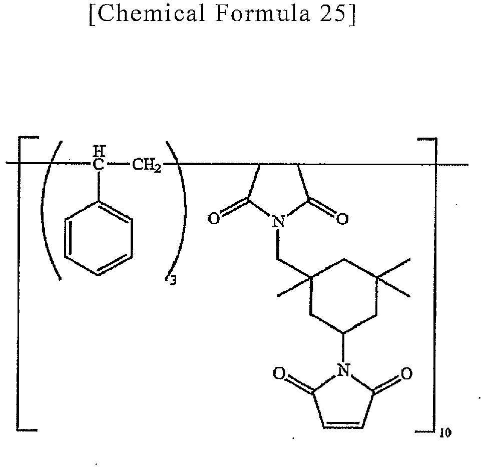

### BMI6: a structure that satisfies the following formula (23)

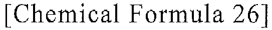

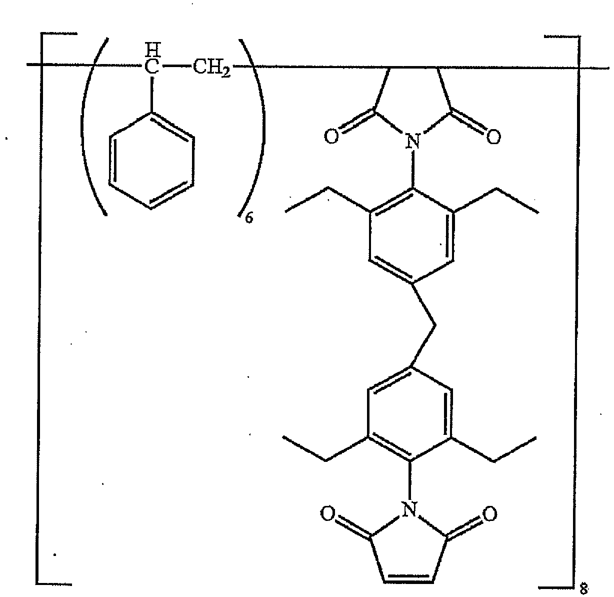

### Polyimide Resin: a polyimide resin produced by the following method

To a 300 mL flask equipped with a thermometer, an agitator, a cooling tube, and a nitrogen inlet tube, 10.0 g (0.7 mol) of 4,4-oxydiphthalic anhydride (ODPA-M, product of MANAC Incorporated), 7.2 g (0.3 mol) of decamethylene bis(trimellitate anhydride) (product of Kurogane Kasei Co., Ltd.), 7.4 g (0.48 mol) of polyoxypropylenediamine (D400, product of Mitsui Fine Chemicals, Inc.), 6.7 g (0.58 mol) of 1,3-bis(3-aminopropyl)-1,1,3,3-tetramethyl disiloxane (BY16-871EG, product of Toray Dow Corning Silicone Corporation), 0.5 g (0.04 mol) of 4,9-dioxadecane-1,12-diamine (B-12, product of BASF), and 30 g of N-methyl-2-pyrrolidone were inserted to prepare a reaction liquid. The reaction liquid was stirred and heated at 180 °C while infusing nitrogen gas to azeotropically remove water and the 50 % N-methyl pyrrolidone, to thereby obtain a polyimide resin. The polyimide obtained was subjected to GPC, which indicated that the mass average molecular-weight (Mw) by standard polystyrene conversion was 53800. The glass transition temperature (Tg) of the polyimide resin obtained was 38 °C.
FG1901: KRATON (registered trade mark) FG1901G, SEBS grafted with MA
D1155: KRATON (registered trade mark) D1155, SBS
SO-C2: silica filler, product of Admatechs, average particle size 0.5 µm
AlN: aluminum nitride H grade, product of Tokuyama Corporation, average particle size 1.1 µm, Mohs' hardness 8, thermal conductivity 200 W/m.K
Cu Filler: spherical copper powder, average particle size 3 µm, surface treatment by stearic acid
Sn72-Bi28: spherical solder, melting point 139 °C, average particle size 3 µm
EA0297: silver flake, average particle size 4 µm, product of Metalor
BHPA: flux, 2,2-bis(hydroxymethyl)propionic acid (product of Tokyo Chemical Industry Co., Ltd.) subjected to pulverization treatment by a jet mill pulverizer (product of Nisshin Engineering Inc., current jet), average particle size 10 µm
THFA: tetrahydrofurfuryl acrylate, Viscoat#150, THFA, product of Osaka Organic Chemical Industry Ltd.
Z-6030: silane coupling agent, 3-methacryloyloxypropyl)=triethoxy silane, product of Toray Dow Corning Silicone Corporation
TRIGONOX 301: 3,6,9-triethyl-3,6,9-trimethyl-1,4,7-triperoxonane, one-hour half-life temperature 146 °C, product of Akzo Nobel
Initiator A: 3,4-di-t-butyl-2,2,5,5-tetramethyl hexane, one-hour half-life temperature 141 °C
Luperox TAH: tert-amyl hydroperoxide, one-hour half-life temperature 183 °C, product of Arkema Inc.
Initiator B: 4,5-dimethyl-4,5-diphenyloctane, one-hour half-life temperature 194°C, product of NOF corporation
Nofmer BC: 2,3-dimethyl-2,3-diphenylbutane, one-hour half-life temperature 234 °C, product of NOF corporation
Initiator C: 3,4-dimethyl-3,4-diphenylhexane, one-hour half-life temperature 211 °C
Percumyl D: dicumyl peroxide, one-hour half-life temperature 136 °C, product of NOF Corporation

### <Property Evaluation of Adhesive Film>

The adhesive films of Examples 1 to 15 and Comparative Examples 1 to 3 were fixed on to a silicon wafer of 50 µm thickness and 200 mm diameter at a heating temperature of 90 °C or 110 °C, at an affixation speed of 12 mm/s. This affixation process was performed for 10 silicon wafers. The adhesive films were evaluated by checking whether or not they are affixed properly without void, and function as adhesive films. The evaluation results are shown in Table 1.
⊚ : all 10 films could be affixed at 90 °C.
○ : all 10 films could be affixed at 90 °C or 110 °C.
× : at least one film showed affixation defects.

### <Heat Resistance>

The adhesive films of Examples 1 to 15 and Comparative Examples 1 to 3 were adhered to a silver-plated PPF-Cu lead frame (land: 10 × 5 mm), and then to a silicon chip, which was plated consecutively with titanium, nickel, and gold, wherein the adherend surface was 5 × 5 mm² gold-plate (thickness of gold plate 0.1 µm, thickness of chip: 400 µm). This was then subjected to thermal curing at 230 °C, 0.5 MPa, under nitrogen atmosphere for 1.5 hours. Half of the cured samples were subjected to a heat resistance test by retaining at 100 °C for 500 hours. The shear adhesive strength was measured for each sample, and the decrease in adhesive strength before and after the heat resistance test were determined. The test was performed using a "Multipurpose Bond Tester 4000 series" by Dage, at a condition of test temperature 260 °C, test height 10 µm, test speed 50 µm/s. The test results are shown in the Table.
⊚ (Good Heat Resistance): Decrease in adhesive strength before and after TCT was less than 10%.
○ (Good Heat Resistance): Decrease in adhesive strength before and after TCT was less than 20%.
Δ (Good Heat Resistance): Decrease in adhesive strength before and after TCT was less than 50%.
× (Inferior Heat Resistance): Decrease in adhesive strength before and after TCT was 50% or more.

In Examples 1 to 10, since the one-hour half-life temperature of the polymerization initiator was 140 °C or higher, the curing reaction did not proceed during the film-formation process, and thus, the films were suitable as adhesive films.

In Comparative Example 2 and 3, since the one-hour half-life temperature of the polymerization initiator was below 140 °C, the curing reaction proceeded during the film-formation process, and thus, the films could not be applied as adhesive films. Further, for this reason, the heat resistance test could not be performed.

In Examples 3, 5, 6, 12, 14, and 15, since most of the resin components were resins with a maleimide structure, thermal degradation after curing could be suppressed. Thus, even after subjecting to the heat resistance test, the adhesive strength hardly decreased. In Examples 1 and 2, since the resin components consisted of resins with a maleimide structure and polyimide resins, thermal degradation after curing could be suppressed. Thus, even after subjecting to the heat resistance test, the adhesive strength did not decrease more than 20%. In Examples 4, 7 to 11, and 13, since the films contain resins with maleimide structures, thermal degradation after curing could be suppressed. Thus, even after subjecting to the heat resistance test, the adhesive strength did not decrease more than 50%.

### DESCRIPTION OF NOTATIONS

1 ..... substrate
2 ..... pressure-sensitive adhesive layer
3, 3' ..... adhesive film (thermosetting-type adhesive film)
4 ..... semiconductor wafer
10, 12 ..... adhesive film with dicing
11 ..... dicing film

## Claims

1. A maleimide adhesive film, which comprises a maleimide resin and a radical initiator with a one-hour half-life temperature of 200°C or higher, wherein the maleimide resin is the bismaleimide resin of General Formula (2),
(In the formula, R₂ and Q₂ are independently selected from the group consisting of structures derived from unsubstituted or substituted aliphatic, alicyclic, alkenyl, aryl, heteroaryl, siloxane, poly(butadiene-co-acrylonitrile) and poly(alkylene oxide), X₅ to X₈ are independently H or an alkyl group with 1 to 6 carbons, R₃ and R₄ are independently H or CH₃ n = 0 to 30) 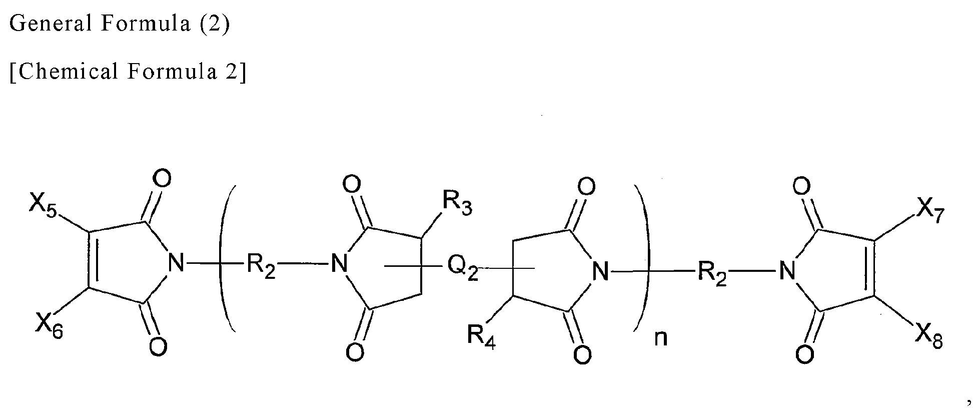 and wherein the mass-average molecular weight of the maleimide resin is 1,000 or more.

2. A maleimide adhesive film, which comprises a maleimide resin and a radical initiator with a one-hour half-life temperature of 200°C or higher, wherein the maleimide resin is the bismaleimide resin of General Formula (3),
(In the formula, R₅ is independently selected from the group consisting of structures derived from unsubstituted or substituted aliphatic, alicyclic, alkenyl, aryl, heteroaryl, siloxane, poly(butadiene-co-acrylonitrile) and poly(alkylene oxide), X₉ to X₁₂ are independently H or an alkyl group with 1 to 6 carbons, n = 0 to 30) 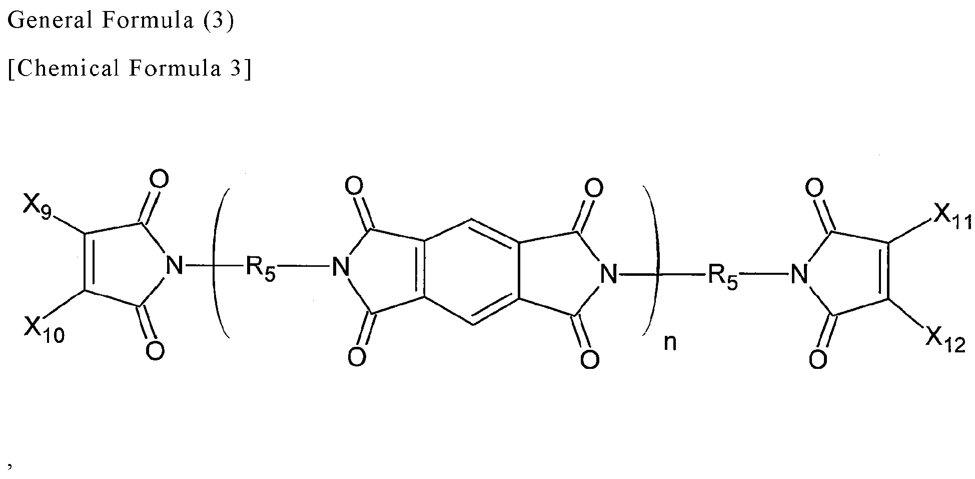 and wherein the mass-average molecular weight of the maleimide resin is 1,000 or more.

3. A maleimide adhesive film, which comprises a maleimide resin and a radical initiator with a one-hour half-life temperature of 200°C or higher, wherein the maleimide resin is the maleimide resin of General Formula (4),
(In the formula, Q₃ is independently selected from the group consisting of structures derived from unsubstituted or substituted aliphatic, alicyclic, alkenyl, aryl, heteroaryl, siloxane, poly(butadiene-co-acrylonitrile) and poly(alkylene oxide), X₁₃, X₁₄ are independently H or an alkyl group with 1 to 6 carbons, Y is a substituted or unsubstituted aliphatic or aromatic.) 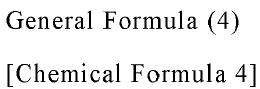 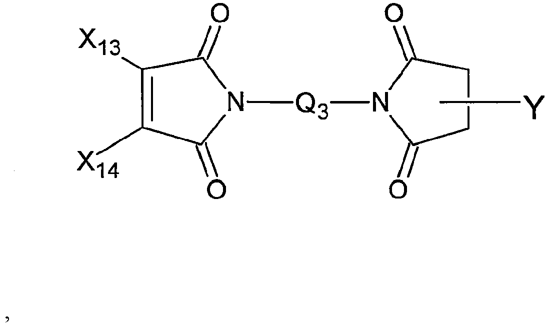 and wherein the mass-average molecular weight of the maleimide resin is 1,000 or more.

4. A maleimide adhesive film, which comprises a maleimide resin and a radical initiator with a one-hour half-life temperature of 200°C or higher, wherein the maleimide resin is a maleimide resin that comprises a plurality of repeating units having the structural formula of General Formula (6),
(In the formula, Q₅ is a substituted or unsubstituted aliphatic part, aromatic part, heteroaromatic part, or siloxane part. X₁₇ and X₁₈ are independently H or an alkyl group with 1 to 6 carbons.) 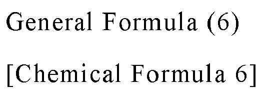 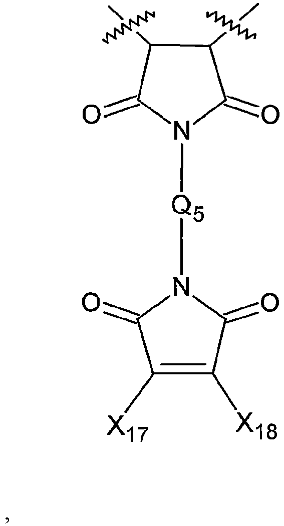 and wherein the mass-average molecular weight of the maleimide resin is 1,000 or more.

5. The maleimide adhesive film according to any one of Claims 1 to 4, wherein one of R₂, R₅, Q₂, Q₃, Q₄, Q₅ comprises a cyclic structure.

6. The maleimide adhesive film according to Claim 5, wherein the cyclic structure is any one of the structures shown in General Formula (7).

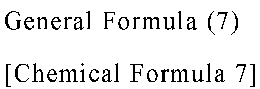

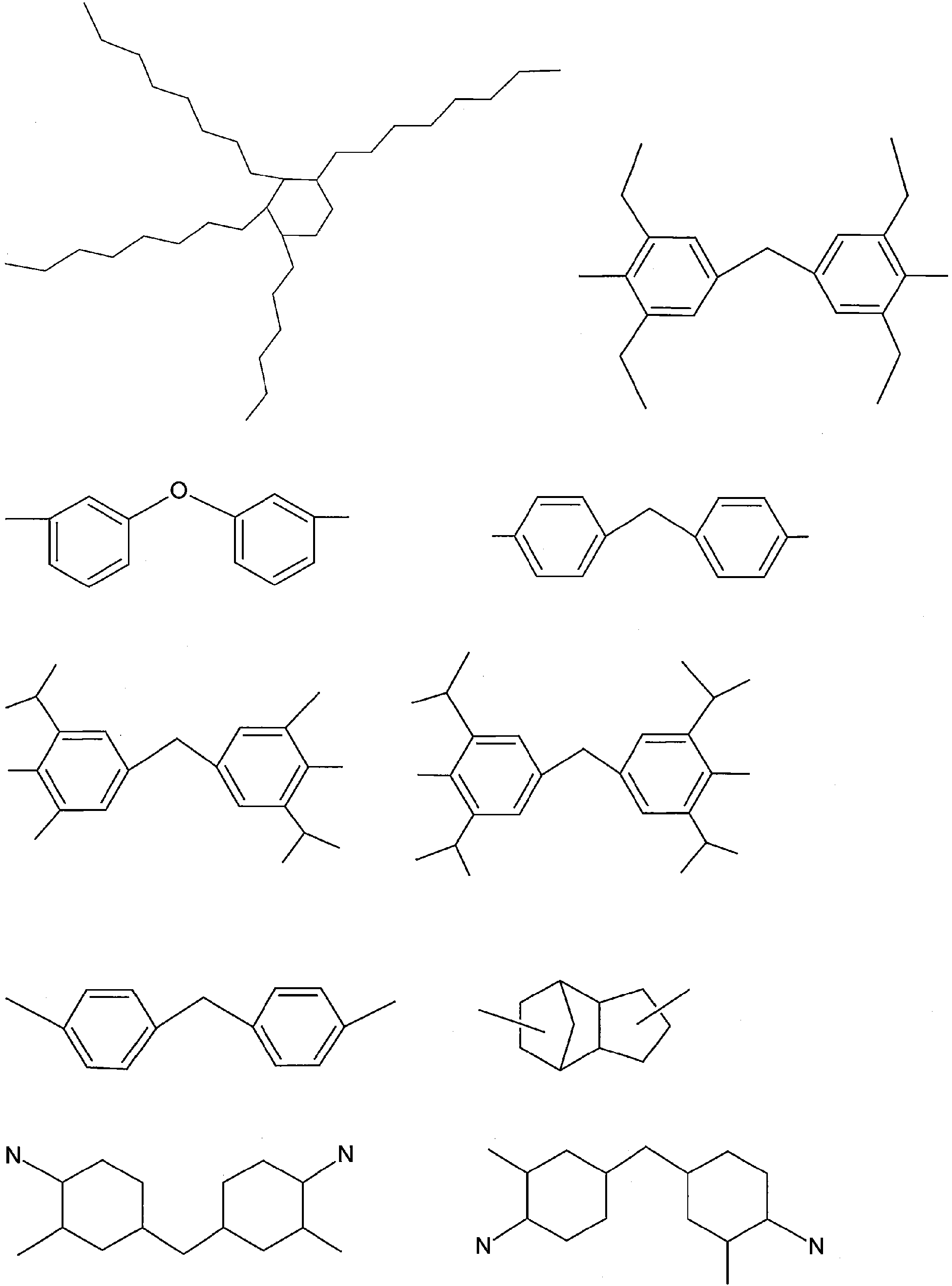

7. The maleimide adhesive film according to any one of Claims 1 to 6, wherein the siloxane part is dimethylsiloxane, methylphenylsiloxane, diphenylsiloxane, or a combination thereof.

8. The maleimide adhesive film according to any one of Claims 1 to 7, wherein the structures derived from substituted aliphatic, alicyclic, alkenyl, aryl, heteroaryl, siloxane, poly(butadiene-co-acrylonitrile) and poly(alkylene oxide) are alkyl group, alkenyl group, alkynyl group, hydroxyl group, oxo group, alkoxy group, mercapto group, cycloalkyl group, substituted cycloalkyl group, heterocyclic group, substituted heterocyclic group, aryl group, substituted aryl group, heteroaryl group, substituted heteroaryl group, aryloxy group, substituted aryloxy group, halogen, haloalkyl group, cyano group, nitro group, nitrone group, amino group, amide group, -C(O)H, acyl group, oxyacyl group, carboxyl group, carbamate group, sulfonyl group, sulfonamide group, sulfuryl group, or -C(O)-, -S-, -S(O)₂-, -OC(O)-O-, -NA-C(O)-, -NAC(O)-NA-, -OC(O)-NA- (in the formula, A is H or an alkyl group with 1 to 6 carbons), and one terminal further contains a substituent that is selected from the substituted groups.

9. The maleimide adhesive film according to any one of Claims 1 to 8, wherein the amount of the maleimide resin is 50 percent by mass or more of the resin component.

10. The maleimide adhesive film according to any one of Claims 1 to 9, which further comprises a filler.

11. A maleimide adhesive film with a dicing tape, which comprises the maleimide adhesive film according to any one of Claims 1 to 10 laminated on to the dicing tape.

## Patentansprüche

1. Maleimid-Klebefilm, der ein Maleimidharz und einen Radikalinitiator mit einer Ein-Stunden-Halbwertstemperatur von 200°C oder höher umfasst, wobei das Maleimidharz das Bismaleimidharz der allgemeinen Formel (2) ist,
(in der Formel sind R₂ und Q₂ unabhängig voneinander ausgewählt aus der Gruppe, bestehend aus Strukturen, die von einer unsubstituierten oder substituierten aliphatischen Verbindung, alizyklischen Verbindung, einem Alkenyl, Aryl, Heteroaryl, Siloxan, Poly(butadien-co-acrylnitril) und Poly(alkylenoxid) abgeleitet sind, X₅ bis X₈ sind unabhängig voneinander H oder eine Alkylgruppe mit 1 bis 6 Kohlenstoffen, R₃ und R₄ sind unabhängig voneinander H oder CH₃, n = 0 bis 30) 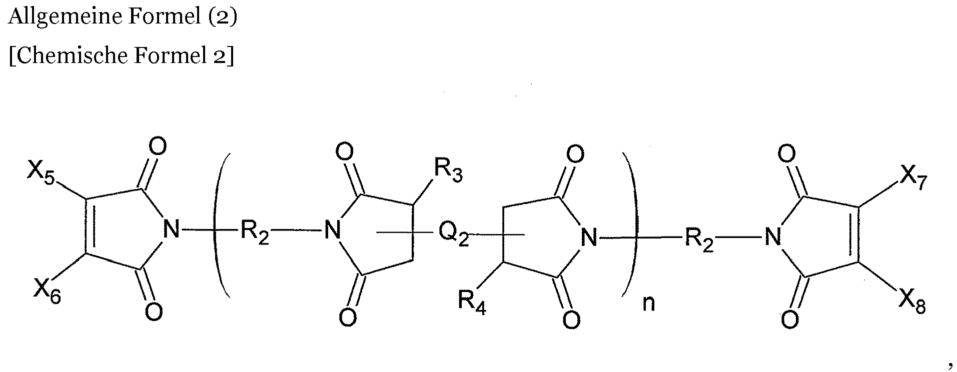 und wobei das Massenmittel-Molekulargewicht des Maleimidharzes 1.000 oder mehr beträgt.

2. Maleimid-Klebefilm, der ein Maleimidharz und einen Radikalinitiator mit einer Ein-Stunden-Halbwertstemperatur von 200°C oder höher umfasst, wobei das Maleimidharz das Bismaleimidharz der allgemeinen Formel (3) ist,
(in der Formel ist R₅ unabhängig ausgewählt aus der Gruppe, bestehend aus Strukturen, die von einer unsubstituierten oder substituierten aliphatischen Verbindung, alizyklischen Verbindung, einem Alkenyl, Aryl, Heteroaryl, Siloxan, Poly(butadien-co-acrylnitril) und Poly(alkylenoxid) abgeleitet sind, X₉ bis X₁₂ sind unabhängig voneinander H oder eine Alkylgruppe mit 1 bis 6 Kohlenstoffen, n = 0 bis 30) 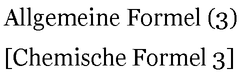 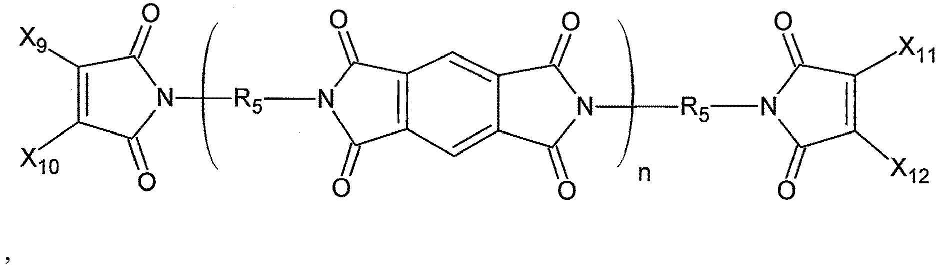 und wobei das Massenmittel-Molekulargewicht des Maleimidharzes 1.000 oder mehr beträgt.

3. Maleimid-Klebefilm, der ein Maleimidharz und einen Radikalinitiator mit einer Ein-Stunden-Halbwertstemperatur von 200°C oder höher umfasst, wobei das Maleimidharz das Maleimidharz der allgemeinen Formel (4) ist,
(in der Formel ist Q₃ unabhängig ausgewählt aus der Gruppe, bestehend aus Strukturen, die von einer unsubstituierten oder substituierten aliphatischen Verbindung, alizyklischen Verbindung, einem Alkenyl, Aryl, Heteroaryl, Siloxan, Poly(butadien-co-acrylnitril) und Poly(alkylenoxid) abgeleitet sind, X₁₃, X₁₄ sind unabhängig voneinander H oder eine Alkylgruppe mit 1 bis 6 Kohlenstoffen, Y ist ein substituierter oder unsubstituierter Aliphat oder Aromat.) 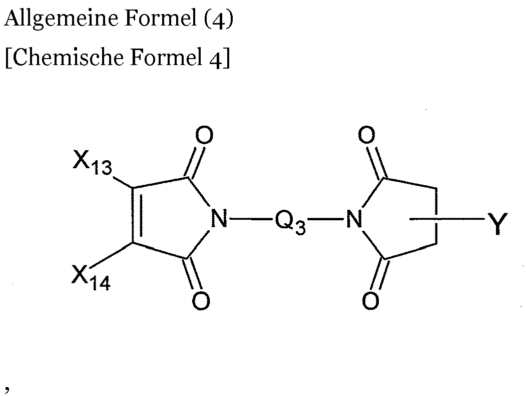 und wobei das Massenmittel-Molekulargewicht des Maleimidharzes 1.000 oder mehr beträgt.

4. Maleimid-Klebefilm, der ein Maleimidharz und einen Radikalinitiator mit einer Ein-Stunden-Halbwertstemperatur von 200°C oder höher umfasst, wobei das Maleimidharz ein Maleimidharz ist, das eine Vielzahl von sich wiederholenden Einheiten mit der Strukturformel der allgemeinen Formel (6) umfasst,
(in der Formel ist Q₅ ein substituierter oder unsubstituierter aliphatischer Teil, aromatischer Teil, heteroaromatischer Teil oder Siloxan-Teil. X₁₇ und X₁₈ sind unabhängig voneinander H oder eine Alkylgruppe mit 1 bis 6 Kohlenstoffen.) 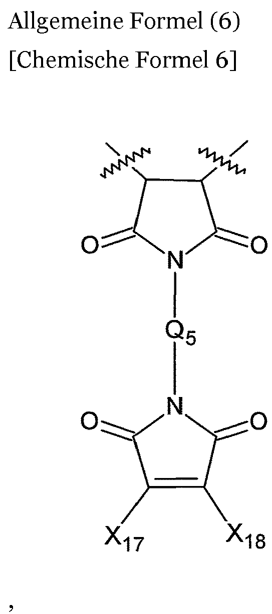 und wobei das Massenmittel-Molekulargewicht des Maleimidharzes 1.000 oder mehr beträgt.

5. Maleimid-Klebefilm nach einem der Ansprüche 1 bis 4, wobei einer von R₂, R₅, Q₂, Q₃, Q₄, Q₅ eine zyklische Struktur umfasst.

6. Maleimid-Klebefilm nach Anspruch 5, wobei die zyklische Struktur eine der in der allgemeinen Formel (7) dargestellten Strukturen ist.

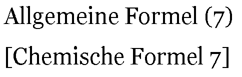

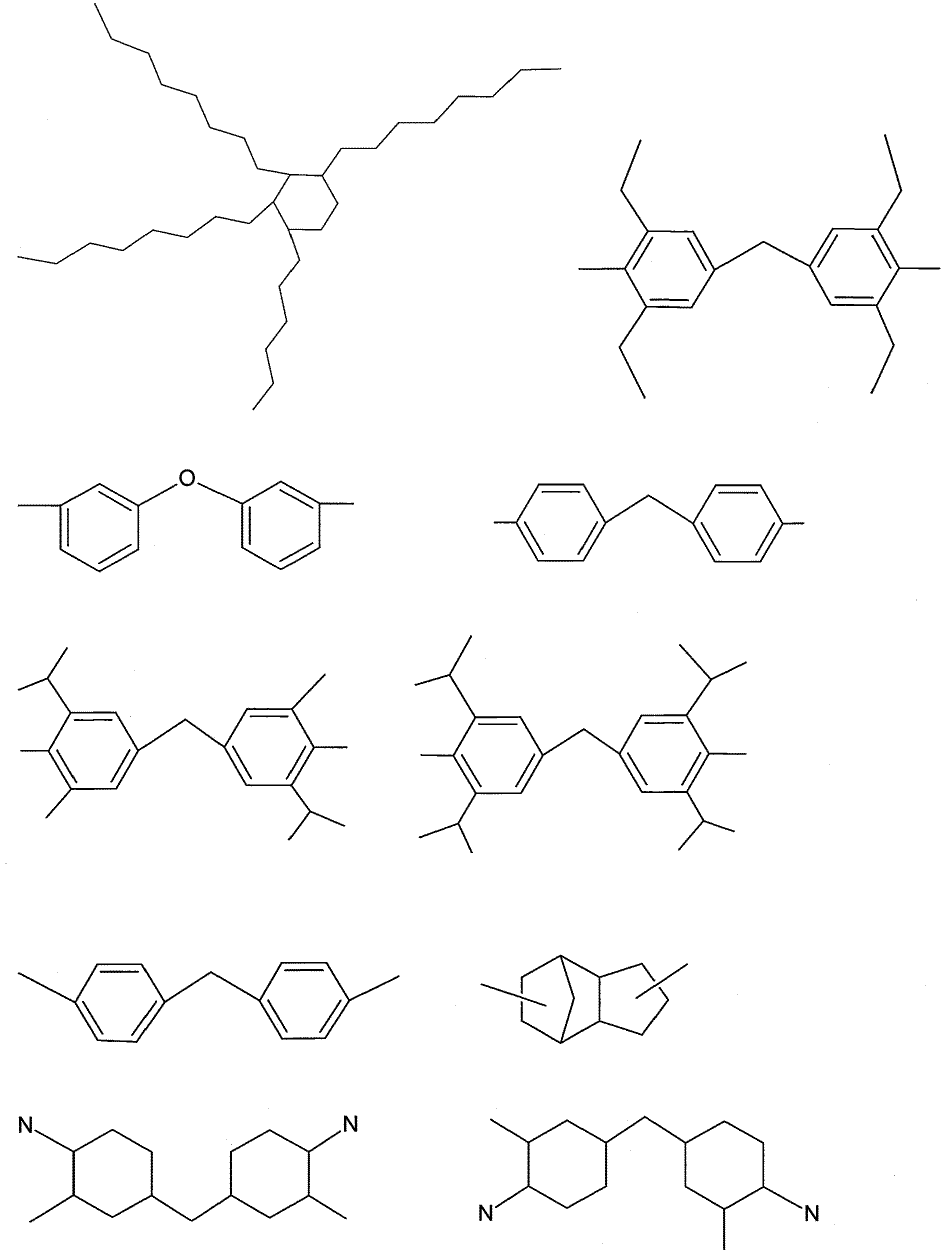

7. Maleimid-Klebefilm nach einem der Ansprüche 1 bis 6, wobei der Siloxan-Teil Dimethylsiloxan, Methylphenylsiloxan, Diphenylsiloxan oder eine Kombination davon ist.

8. Maleimid-Klebefilm nach einem der Ansprüche 1 bis 7, wobei die Strukturen, die von einer substituierten aliphatischen Verbindung, alizyklischen Verbindung, einem Alkenyl, Aryl, Heteroaryl, Siloxan, Poly(butadien-co-acrylnitril) und Poly(alkylenoxid) abgeleitet sind, eine Alkylgruppe, Alkenylgruppe, Alkinylgruppe, Hydroxylgruppe, Oxogruppe, Alkoxygruppe, Mercaptogruppe, Cycloalkylgruppe, substituierte Cycloalkylgruppe, heterocyclische Gruppe, substituierte heterocyclische Gruppe, Arylgruppe, substituierte Arylgruppe, Heteroarylgruppe, substituierte Heteroarylgruppe, Aryloxygruppe, substituierte Aryloxygruppe, Halogen, Haloalkylgruppe, Cyanogruppe, Nitrogruppe, Nitrongruppe, Aminogruppe, Amidgruppe, -C(O)H, Acylgruppe, Oxyacylgruppe, Carboxylgruppe, Carbamatgruppe, Sulfonylgruppe, Sulfonamidgruppe, Sulfurylgruppe, oder -C(O)-, -S-, -S(O)₂-, -OC(O)-O-, -NA-C(O)-, -NAC(O)-NA-, -OC(O)-NA- (in der Formel ist A H oder eine Alkylgruppe mit 1 bis 6 Kohlenstoffen) sind, und ein Ende ferner einen Substituenten enthält, der aus den substituierten Gruppen ausgewählt ist.

9. Maleimid-Klebefilm nach einem der Ansprüche 1 bis 8, wobei der Anteil des Maleimidharzes 50 Massenprozent oder mehr der Harzkomponente beträgt.

10. Maleimid-Klebefilm nach einem der Ansprüche 1 bis 9, der ferner einen Füllstoff umfasst.

11. Maleimid-Klebefilm mit einer Sägefolie (dicing tape), der den Maleimid-Klebefilm nach einem der Ansprüche 1 bis 10 umfasst, der auf die Sägefolie laminiert ist.

## Revendications

1. Film adhésif de maléimide, qui comprend une résine maléimide et un amorceur radicalaire ayant une température de demi-vie d'une heure supérieure ou égale à 200 °C, dans lequel la résine maléimide est la résine bismaléimide de formule générale (2),
(dans la formule, R₂ et Q₂ sont choisis indépendamment dans le groupe constitué par les structures dérivées de groupes aliphatique, alicyclique, alcényle, aryle, hétéroaryle, siloxane, poly(butadiène-co-acrylonitrile) et poly(oxyde d'alkylène) non substitués ou substitués, X₅ à X₈ sont indépendamment H ou un groupe alkyle ayant de 1 à 6 carbones, R₃ et R₄ sont indépendamment H ou CH₃, n = 0 à 30) 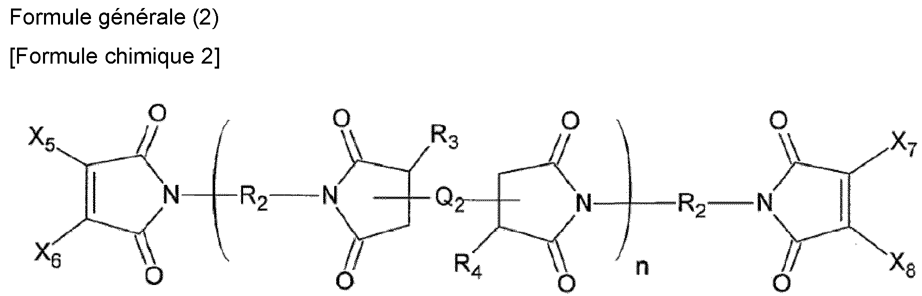 et dans lequel le poids moléculaire moyen en masse de la résine maléimide est supérieur ou égal à 1 000.

2. Film adhésif de maléimide, qui comprend une résine maléimide et un amorceur radicalaire ayant une température de demi-vie d'une heure supérieure ou égale à 200 °C, dans lequel la résine maléimide est la résine bismaléimide de formule générale (3),
(dans la formule, R₅ est choisi indépendamment dans le groupe constitué par les structures dérivées de groupes aliphatique, alicyclique, alcényle, aryle, hétéroaryle, siloxane, poly(butadiène-co-acrylonitrile) et poly(oxyde d'alkylène) non substitués ou substitués, X₉ à X₁₂ sont indépendamment H ou un groupe alkyle ayant de 1 à 6 carbones, n = 0 à 30) 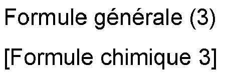 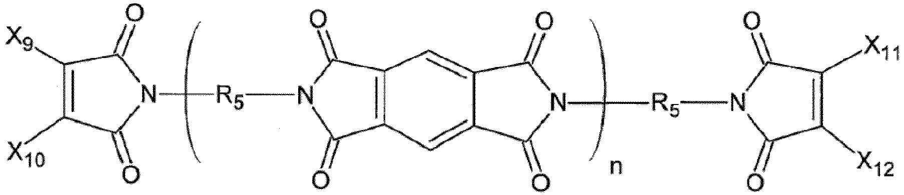 et dans lequel le poids moléculaire moyen en masse de la résine maléimide est supérieur ou égal à 1 000.

3. Film adhésif de maléimide, qui comprend une résine maléimide et un amorceur radicalaire ayant une température de demi-vie d'une heure supérieure ou égale à 200 °C, dans lequel la résine maléimide est la résine maléimide de formule générale (4),
(dans la formule, Q₃ est choisi indépendamment dans le groupe constitué par les structures dérivées de groupes aliphatique, alicyclique, alcényle, aryle, hétéroaryle, siloxane, poly(butadiène-co-acrylonitrile) et poly(oxyde d'alkylène) non substitués ou substitués, X₁₃, X₁₄ sont indépendamment H ou un groupe alkyle ayant de 1 à 6 carbones, Y est un groupe aliphatique ou aromatique substitué ou non substitué) 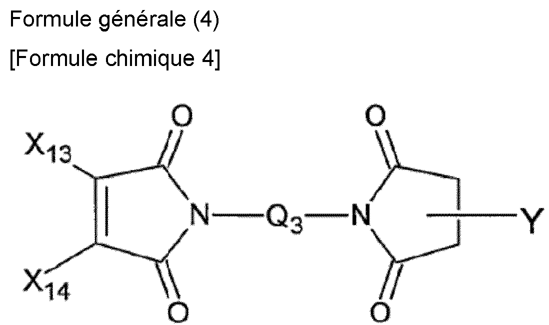 et dans lequel le poids moléculaire moyen en masse de la résine maléimide est supérieur ou égal à 1 000.

4. Film adhésif de maléimide, qui comprend une résine maléimide et un amorceur radicalaire ayant une température de demi-vie d'une heure supérieure ou égale à 200 °C, dans lequel la résine maléimide est une résine maléimide qui comprend une pluralité de motifs répétitifs ayant la formule développée de formule générale (6),
(dans la formule, Q₅ est une partie aliphatique, une partie aromatique, une partie hétéroaromatique ou une partie siloxane substituée ou non substitué, X₁₇ et X₁₈ sont indépendamment H ou un groupe alkyle ayant de 1 à 6 carbones) 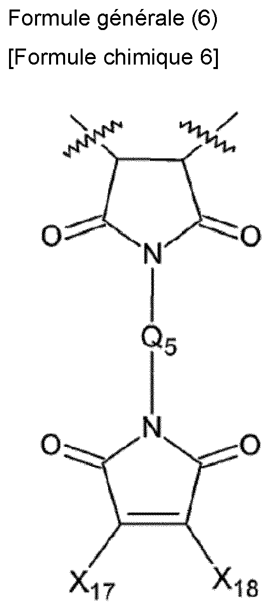 et dans lequel le poids moléculaire moyen en masse de la résine maléimide est supérieur ou égal à 1 000.

5. Film adhésif de maléimide selon l'une quelconque des revendications 1 à 4, dans lequel l'un de R₂, R₅, Q₂, Q₃, Q₄, Q₅ comprend une structure cyclique.

6. Film adhésif de maléimide selon la revendication 5, dans lequel la structure cyclique est l'une quelconque des structures illustrées dans la formule générale (7)

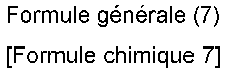

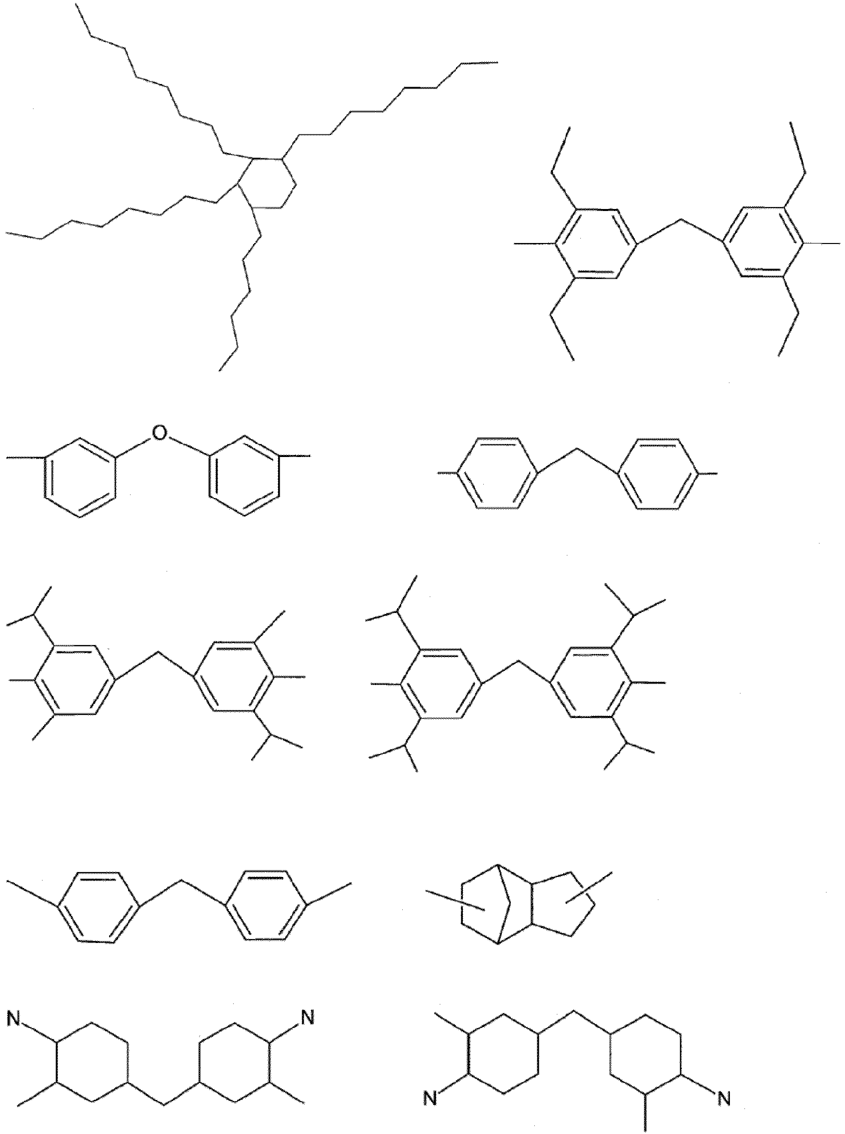

7. Film adhésif de maléimide selon l'une quelconque des revendications 1 à 6, dans lequel la partie siloxane est le diméthylsiloxane, le méthylphénylsiloxane, le diphénylsiloxane ou une combinaison de ceux-ci.

8. Film adhésif de maléimide selon l'une quelconque des revendications 1 à 7, dans lequel les structures dérivées de groupes aliphatique, alicyclique, alcényle, aryle, hétéroaryle, siloxane, poly(butadiène-co-acrylonitrile) et poly(oxyde d'alkylène) substitués sont un groupe alkyle, un groupe alcényle, un groupe alcynyle, un groupe hydroxyle, un groupe oxo, un groupe alcoxy, un groupe mercapto, un groupe cycloalkyle, un groupe cycloalkyle substitué, un groupe hétérocyclique, un groupe hétérocyclique substitué, un groupe aryle, un groupe aryle substitué, un groupe hétéroaryle, un groupe hétéroaryle substitué, un groupe aryloxy, un groupe aryloxy substitué, un atome d'halogène, un groupe halogénoalkyle, un groupe cyano, un groupe nitro, un groupe nitrone, un groupe amino, un groupe amide, -C(O)H, un groupe acyle, un groupe oxyacyle, un groupe carboxyle, un groupe carbamate, un groupe sulfonyle, un groupe sulfonamide, un groupe sulfuryle, ou -C(O)-, -S-, -S(O)₂-, -OC(O)-O-, -NA-C(O)-, -NAC(O)-NA-, -OC(O)-NA- (dans la formule, A est H ou un groupe alkyle ayant de 1 à 6 carbones), et une extrémité contient en outre un substituant qui est choisi parmi les groupes substitués.

9. Film adhésif de maléimide selon l'une quelconque des revendications 1 à 8, dans lequel la quantité de la résine maléimide est supérieure ou égale à 50 % en masse du composant résine.

10. Film adhésif de maléimide selon l'une quelconque des revendications 1 à 9, qui comprend en outre une charge.

11. Film adhésif de maléimide avec bande de découpage, qui comprend le film adhésif de maléimide selon l'une quelconque des revendications 1 à 10 stratifié sur la bande de découpage.
